# EUROPÄISCHE PATENTSCHRIFT

(11) **EP 4 594 445 B1**
(45) Veröffentlichungstag und Bekanntmachung des Hinweises auf die Patenterteilung: **01.07.2026**
(21) Anmeldenummer: 23789498.5
(22) Anmeldetag: 28.09.2023
(51) Int. Cl.: C09K 11/06, C07F 5/02, C07F 7/08, C07F 9/6596, H10K 85/30, H10K 30/30

(54) **CHEMISCHE VERBINDUNG, OPTOELEKTRONISCHES BAUELEMENT MIT MINDESTENS EINER SOLCHEN CHEMISCHEN VERBINDUNG, UND VERWENDUNG MINDESTENS EINER SOLCHEN CHEMISCHEN VERBINDUNG IN EINEM OPTOELEKTRONISCHEN BAUELEMENT**
CHEMICAL COMPOSITION, OPTOELECTRONIC COMPONENT COMPRISING AT LEAST ONE CHEMICAL COMPOSITION OF THIS TYPE, AND USE OF AT LEAST ONE CHEMICAL COMPOSITION OF THIS TYPE IN AN OPTOELECTRONIC COMPONENT
COMPOSÉ CHIMIQUE, COMPOSANT OPTOÉLECTRONIQUE COMPRENANT AU MOINS UN TEL COMPOSÉ CHIMIQUE, ET UTILISATION D'AU MOINS UN TEL COMPOSÉ CHIMIQUE DANS UN COMPOSANT OPTOÉLECTRONIQUE

(30) Priorität: 30.09.2022 DE 102022125417
(43) Veröffentlichungstag der Anmeldung: 06.08.2025
(73) Patentinhaber: Heliatek GmbH, 01139 Dresden (DE)
(72) Erfinder: COUTABLE, Ludovic, 89077 Ulm (DE); FITZNER, Roland, 89077 Ulm (DE); MATTERSTEIG, Gunter, 89077 Ulm (DE)
(86) Internationale Anmeldenummer: PCT/DE2023/100727
(87) Internationale Veröffentlichungsnummer: WO 2024/067923

(56) Entgegenhaltungen:
- YUE LI ET AL: "Highly Efficient Deep-Red- to Near-Infrared-Absorbing and Emissive Benzo/Naphtho[b]furan-Fused Boron Dipyrromethene (BODIPY)", CHEMPHOTOCHEM, JOHN WILEY & SONS, INC, HOBOKEN, USA, vol. 2, no. 12, 24 September 2018 (2018-09-24), pages 1017 - 1021, XP072279454, ISSN: 2367-0932, DOI: 10.1002/CPTC.201800159

## Beschreibung

Die vorliegende Erfindung betrifft eine chemische Verbindung, ein optoelektronisches Bauelement mit mindestens einer solchen chemischen Verbindung, und eine Verwendung mindestens einer solchen chemischen Verbindung in einem optoelektronischen Bauelement.

Organische optoelektronische Bauelemente weisen eine photoaktive Schicht auf, in der bei Einfall elektromagnetischer Strahlung Ladungsträger, insbesondere gebundene Elektronen-Loch-Paare (Exzitonen), erzeugt werden. Die Exzitonen gelangen durch Diffusion an eine Grenzfläche, an der Elektronen und Löcher voneinander getrennt werden. Das Material, welches die Elektronen aufnimmt wird als Akzeptor bezeichnet, und das Material, welches die Löcher aufnimmt wird als Donor bezeichnet. Organische optoelektronische Bauelemente ermöglichen die Umwandlung von elektromagnetischer Strahlung in elektrischen Strom unter Ausnutzung des photoelektrischen Effekts. Für eine derartige Umwandlung von elektromagnetischer Strahlung werden Absorbermaterialien benötigt, die gute Absorptionseigenschaften zeigen.

Organische optoelektronische Bauelemente sind aus dem Stand der Technik bekannt. WO2004/083958A2 offenbart ein photoaktives Bauelement, insbesondere eine Solarzelle, bestehend aus organischen Schichten aus einer oder mehreren aufeinander gestapelten pi-, ni- und/oder pin-Diode. WO2011/161108A1 offenbart einen Aufbau einer organischen Solarzelle bestehend aus einer pin- oder nip-Diode. Eine pin-Solarzelle besteht dabei aus einem Substrat mit einer darauf angeordneten Elektrode, p-Schicht(en), i-Schicht(en), n-Schicht(en) und einer Gegenelektrode. Hierbei bedeutet n bzw. p eine n- bzw. p-Dotierung, die zu einer Erhöhung der Dichte freier Elektronen bzw. Löcher im thermischen Gleichgewichtszustand führt.

Die Bezeichnung i-Schicht bezeichnet eine undotierte Schicht (intrinsische Schicht) mit einem Absorbermaterial oder einer Mischung mehrerer Absorbermaterialien. Eine oder mehrere i-Schichten können dabei aus einem Material (planar heterojunctions) als auch aus einer Mischung zweier oder mehrerer Materialien (bulk heterojunctions) bestehen. Unter einem Absorbermaterial, also einem Absorber, wird insbesondere eine Verbindung verstanden, die Licht in einem bestimmten Wellenlängenbereich absorbiert. Unter einer Absorberschicht wird dementsprechend insbesondere eine Schicht in einem optoelektronischen Bauelement verstanden, die mindestens ein Absorbermaterial aufweist.

Aus dem Stand der Technik sind zahlreiche polymere und nicht-polymere Absorbermaterialien für organische photovoltaische Elemente im roten und nahinfraroten (NIR) Spektralbereich zwischen 600 nm und 1400 nm bekannt. Dabei haben sich im Bereich nicht-polymerer Absorbermaterialien insbesondere Materialien der Stoffklasse der BODIPYs für den nahinfraroten Spektralbereich als geeignet erweisen.

Umezawa et al. ("Bright, Color-Tunable Fluorescent Dyes in the Visible-Near-Infrared Region", J.Am.Chem.Soc., 2008, 130, 5, 1550-1551) offenbart BODIPY-Strukturen als Fluoreszenz-Farbstoffe, die in der meso-Position unsubstituiert sind, oder eine fluorierte Alkylkette tragen.

Li et al. ("Small Molecule Near-Infrared Boron Dipyrromethene Donors for Organic Tandem Solar Cells", J.Am.Chem.Soc., 2017, 139, 13636-13639) offenbart BODIPY Strukturen, die in der meso-Position perfluorierte Alkylketten tragen, und als NIR-Donormaterialien in organischen Solarzellen eingesetzt werden können.

Yue Li et al. (CHEMPHOTOCHEM, JOHN WILEY & SONS, INC, HOBOKEN, USA, Bd. 2, Nr. 12, 24. September 2018 (2018-09-24), Seiten 1017-1021,ISSN: 2367-0932, DOI: 10.1002/CPTC.201800159) offenbart weitere organische Verbindungen zum Einsatz in optoelektronischen Bauelementen.

Die aus dem Stand der Technik bekannten Absorber im roten und nahinfraroten Spektralbereich sind noch nicht zufriedenstellend. Die bekannten Absorbermaterialien sind zwar für photoaktive Schichten in organischen photovoltaischen Elementen, also organischen Solarzellen, geeignet, allerdings bedarf es einer Verbesserung der Absorptionseigenschaften der Absorbermaterialien.

Die Effizienz eines organischen photovoltaischen Elements hängt unter anderem vom Absorptionsverhalten der organischen Materialien, also der Absorbermaterialien, in der photoaktiven Schicht ab. Es besteht insbesondere Bedarf an Absorbermaterialien, insbesondere Donoren, mit steiler Absorptionskante für den Einsatz in NIR-Subzellen von Tandem- oder Multijunction-Solarzellen. Die Absorptionsbande des NIR-Absorbers sollte bevorzugt nicht zu weit in den roten Spektralbereich reichen, um parasitäre Absorption mit einer angrenzenden Subzelle zu vermeiden. Es sind insbesondere Absorbermaterialien mit geringerer parasitärer Absorption zur roten Subzelle bei einem steileren Absorptionsspektrum wünschenswert.

Der Erfindung liegt daher die Aufgabe zugrunde, eine chemische Verbindung, ein optoelektronisches Bauelement mit mindestens einer solchen chemischen Verbindung, und eine Verwendung mindestens einer solchen chemischen Verbindung in einem optoelektronischen Bauelement bereitzustellen, wobei die genannten Nachteile nicht auftreten, und wobei die chemischen Verbindungen insbesondere verbesserte Absorptionseigenschaften mit einer steilen Absorptionskante aufweisen.

Die Aufgabe wird durch die Gegenstände der unabhängigen Ansprüche gelöst. Vorteilhafte Ausgestaltungen ergeben sich aus den Unteransprüchen.

Die Aufgabe wird insbesondere gelöst, durch eine chemische Verbindung der allgemeinen Formel Ia oder Ib 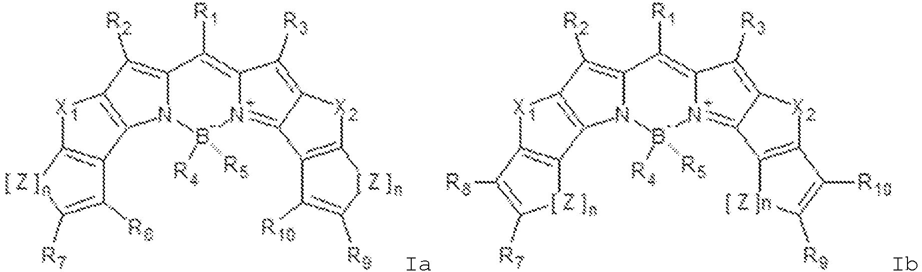 dadurch gekennzeichnet, dass X₁ und X₂ unabhängig voneinander O, S, oder NR₆ sind, mit R₆ ausgewählt aus der Gruppe bestehend aus H, Alkyl, Alkoxy, Amino, Aryl, und Heteroaryl, R₁ ausgewählt ist aus der Gruppe bestehend aus F, fluoriertem oder teilfluoriertem Alkyl, und einem aromatischen heterocyclischen 5-Ring oder 6-Ring oder einem aromatischen homocyclischen 6-Ring, R₂ und R₃ jeweils unabhängig voneinander ausgewählt sind aus der Gruppe bestehend aus H, Halogen, CN, Alkyl, Alkoxy, Amino, Aryl und Heteroaryl, R₄ und R₅ jeweils unabhängig voneinander ausgewählt sind aus der Gruppe bestehend aus Halogen, bevorzugt F, und fluoriertem oder teilfluoriertem Alkyl, mit Z unabhängig voneinander ausgewählt aus der Gruppe bestehend aus O, S, CH₂, CHR₁₁, CR₁₂R₁₃, SiHR₁₁, SiR₁₂R₁₃, NH, NR₁₄, PR₁₅, mit R₁₁, R₁₂, R₁₃, R₁₄ und R₁₅ unabhängig voneinander ausgewählt aus der Gruppe bestehend aus Halogen, Alkyl, Alkoxy, Amino, Aryl, und Heteroaryl, mit n unabhängig voneinander 1 oder 2, wobei R₇ und R₈ und/oder R₉ und R₁₀ jeweils zusammen einen heterocyclischen 5-Ring oder 6-Ring mit mindestens einem Heteroatom ausgewählt aus der Gruppe bestehend aus O, S, N, Si oder P, oder einen homocyclischen 6-Ring bilden, wobei der heterocyclische 5-Ring oder 6-Ring oder der homocyclische 6-Ring jeweils weiter anelliert sein kann.

Erfindungsgemäß wird insbesondere die Molekülstruktur von BODIPY-Verbindungen durch die Einführung einer verbrückenden Einheit zwischen dem BODIPY-Kern und den beiden lateralen Einheiten versteift, insbesondere mittels eines 5-Rings oder 6-Rings zwischen dem BODIPY-Kern und jeweils der lateralen Einheit, wobei insbesondere an dem BODIPY-Kern auf beiden Seiten die laterale Einheit mit mindestens zwei Ringen anelliert ist. Die dadurch erhaltene Versteifung oder Planarisierung von Molekülstrukturen in BODIPY-Verbindungen führt zu steileren Absorptionskanten und rotverschobenen Absorptionsmaxima.

Unter einer Substitution wird insbesondere der Austausch von H durch einen Substituenten verstanden. Unter einem Substituenten werden insbesondere alle Atome und Atomgruppen außer Wasserstoff verstanden, bevorzugt ein Halogen, eine Alkyl-Gruppe, dabei kann die Alkyl-Gruppe linear oder verzweigt sein, eine Alkenyl-Gruppe, eine Alkinyl-Gruppe, eine Amino-Gruppe, eine Alkoxy-Gruppe, eine Thioalkoxy-Gruppe, eine Aryl-Gruppe, oder eine Heteroaryl-Gruppe. Unter einem Halogen wird insbesondere F, Cl oder Br verstanden, bevorzugt F.

Unter einem Heteroatom wird insbesondere ein Atom ausgewählt aus der Gruppe bestehend aus O, S, Se, Si, B, N oder P verstanden, bevorzugt ausgewählt aus der Gruppe bestehend aus O, S, oder N. Die erfindungsgemäßen chemischen Verbindungen weisen Vorteile im Vergleich zum Stand der Technik auf. Vorteilhafterweise können verbesserte Absorbermaterialien, insbesondere Donoren, für optoelektronische Bauelemente bereitgestellt werden. Vorteilhafterweise weisen die Verbindungen eine steile Absorptionskante im Bereich größer als 850 nm, bevorzugt größer als 870 nm, insbesondere bevorzugt größer als 900 nm auf, und sind deshalb insbesondere für den Einsatz in Subzellen von Tandem- oder Multijunction-Solarzellen geeignet. Die Absorptionskante der verbrückten chemischen Verbindungen verläuft insbesondere im Vergleich mit entsprechenden unverbrückten Verbindungen steiler. Vorteilhafterweise werden Absorbermaterialien für den roten und nah-infraroten Spektralbereich mit einer steilen Absorptionskante bereitgestellt, die insbesondere in einer Subzelle einer Tandem- oder Multijunction-Zelle geringere parasitäre Absorption zeigen, bevorzugt reicht die Absorption der Verbindungen nicht weit in den NIR-Bereich hinein. Vorteilhafterweise wird die Überlappung mit dem Absorptionsbereich der roten Subzelle reduziert. Vorteilhafterweise weisen die erfindungsgemäßen Verbindungen besonders gute Verdampfbarkeit auf.

Unter einer verbrückten chemischen Verbindung wird im Zusammenhang mit der Erfindung im Gegensatz zu einer unverbrückten chemischen Verbindung eine BODIPY-Verbindung mit einer verbrückenden Einheit zwischen dem BODIPY-Kern und jeweils zwei lateralen Einheiten des BODIPY-Kerns verstanden, insbesondere mittels eines 5-Rings oder 6-Rings zwischen dem BODIPY-Kern und jeweils zwei lateralen Einheiten, wobei insbesondere an dem BODIPY-Kern auf beiden Seiten jeweils eine laterale Einheit umfassend mindestens zwei Ringe anelliert ist.

Unter einer Absorptionskante wird insbesondere ein sprunghafter Übergang von schwacher zu stärkerer Absorption verstanden, der an einer bestimmten Stelle eines elektromagnetischen Spektrums auftritt.

Gemäß einer Weiterbildung der Erfindung ist vorgesehen, dass R₁ ausgewählt ist aus der Gruppe bestehend aus F, CF₃, C₂F₅, und einem aromatischen heterocyclischen 5-Ring oder 6-Ring oder einem aromatischen homocyclischen 6-Ring, wobei bevorzugt mindestens ein H-Atom durch F, Cl und/oder CF₃ substituiert ist, bevorzugt einem aromatischen heterocyclischen 6-Ring oder einem aromatischen homocyclischen 6-Ring, wobei mindestens zwei H-Atome, durch F, Cl und/oder CF₃ substituiert sind.

Gemäß einer Weiterbildung der Erfindung ist vorgesehen, dass R₇ und R₈ und/oder R₉ und R₁₀ jeweils zusammen einen aromatischen homocyclischen 6-Ring bilden, wobei bevorzugt mindestens ein H-Atom des homocyclischen 6-Rings durch Halogen, Alkyl, Alkoxy, Aryl oder Heteroaryl substituiert ist, und/oder der homocyclische 6-Ring nicht weiter anelliert ist.

Gemäß einer Weiterbildung der Erfindung ist vorgesehen, dass R₇ und R₈ und/oder R₉ und R₁₀ jeweils zusammen einen aromatischen heterocyclischen 5-Ring oder 6-Ring mit mindestens einem Heteroatom ausgewählt aus der Gruppe bestehend aus O, S, N, Si oder P bilden, wobei bevorzugt mindestens ein H-Atom des heterocyclischen 5-Rings oder 6-Rings durch Halogen, Alkyl, Alkoxy, Aryl oder Heteroaryl substituiert ist, und/oder der heterocyclische 5-Ring oder 6-Ring nicht weiter anelliert ist.

In einer bevorzugten Ausführungsform der Erfindung bilden R₇ und R₈ und/oder R₉ und R₁₀ jeweils zusammen einen heterocyclischen 5-Ring oder 6-Ring mit mindestens einem Heteroatom ausgewählt aus O, S oder N, wobei bevorzugt der heterocyclische 5-Ring oder 6-Ring nicht substituiert ist, oder einen homocyclischen 6-Ring.

In einer bevorzugten Ausführungsform der Erfindung ist X₁ gleich X₂.

In einer bevorzugten Ausführungsform der Erfindung sind R₂ und R₃ H oder Alkyl, bevorzugt H, Methyl, Ethyl, oder Propyl.

In einer bevorzugten Ausführungsform der Erfindung sind R₄ und R₅ ausgewählt aus der Gruppe bestehend aus F und CF₃, insbesondere bevorzugt sind R₄ und R₅ F.

Gemäß einer Weiterbildung der Erfindung ist vorgesehen, dass R₂ gleich R₃ ist, R₄ gleich R₅ ist, und/oder R₇ und R₈ gleich R₉ und R₁₀ sind.

In einer bevorzugten Ausführungsform der Erfindung sind Z und n jeweils gleich.

In einer bevorzugten Ausführungsform der Erfindung sind R₇ gleich R₉ und R₈ gleich R₁₀.

In einer bevorzugten Ausführungsform der Erfindung ist R₁ ein heterocyclischer 5-Ring oder 6-Ring mit mindestens einem sp2-hybridisierten N-Atom mit einem freien Elektronenpaar im Ringsystem ist, bevorzugt ist R₁ ausgewählt aus der Gruppe bestehend aus substituiertem oder nicht-substituiertem Imidazol, Pyrazol, Triazol, Tetrazol, Pyridin, Pyrimidin, Pyrazin, Pyridazin, Triazin, Oxazol, Isoxazol, Thiazol, und Isothiazol.

Gemäß einer Weiterbildung der Erfindung ist vorgesehen, dass die chemische Verbindung die allgemeine Formel IIa, IIb, IIc und/oder IId aufweist 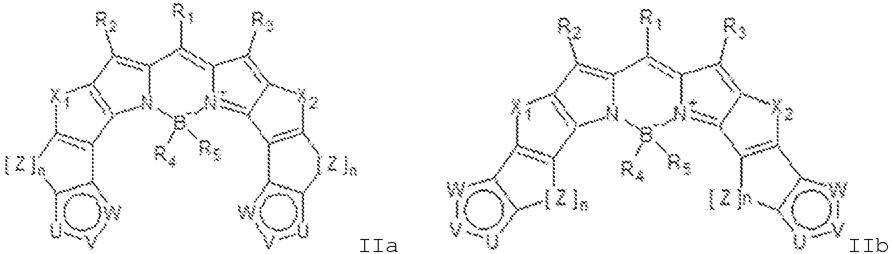 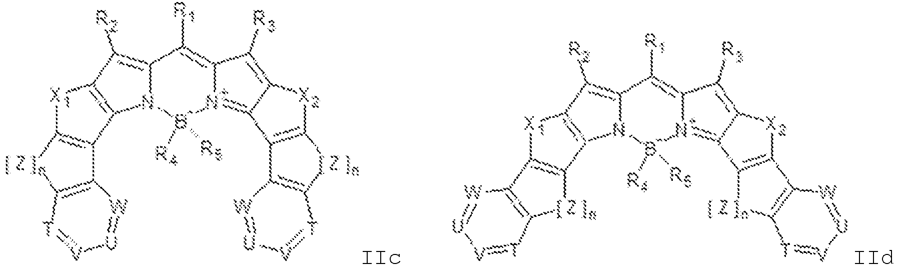 mit U, V und W der Formel IIa und IIb unabhängig voneinander ausgewählt aus der Gruppe bestehend aus CR₁₆, O, S, N, NR₁₇ mit R₁₆ und R₁₇ unabhängig voneinander ausgewählt aus der Gruppe bestehend aus H, Halogen, Alkyl, Alkoxy, Alkylthiooxy, Amino, Aryl, und Heteroaryl, mit T, U, V und W der Formel IIc und IId unabhängig voneinander ausgewählt aus der Gruppe bestehend aus CH, CR₁₈ und N mit R₁₈ unabhängig voneinander ausgewählt aus der Gruppe bestehend aus Halogen, Alkyl, Alkoxy, Alkylthiooxy, Amino, Aryl, und Heteroaryl, wobei an U, V und W der Formel IIa und IIb oder an T, U, V und W der Formel IIc und IId ein heterocyclischer 5-Ring oder 6-Ring mit mindestens einem Heteroatom ausgewählt aus der Gruppe bestehend aus O, S, und N oder ein homocyclischer 6-Ring anelliert sein kann, mit Z unabhängig voneinander ausgewählt aus der Gruppe bestehend aus O, S, CH₂, CHR₁₁, CR₁₂R₁₃, SiHR₁₁, SiR₁₂R₁₃, NH, NR₁₄, PR₁₅, mit R₁₁, R₁₂, R₁₃, R₁₄ und R₁₅ unabhängig voneinander ausgewählt aus der Gruppe bestehend aus Alkyl, Alkoxy, Amino, Aryl, und Heteroaryl, und mit n unabhängig voneinander 1 oder 2.

In einer bevorzugten Ausführungsform der Erfindung sind X₁ und X₂ gleich O oder S, R₂ und R₃ H, und ist R₄ und R₅ F.

Gemäß einer Weiterbildung der Erfindung ist vorgesehen, dass mindestens ein U, V, und W der Formel IIa und IIb ein O oder S ist, bevorzugt U oder W, wobei T, U, V und W der Formel IIc und IId unabhängig voneinander ausgewählt sind aus der Gruppe bestehend aus CH und CR₁₈ mit R₁₈ unabhängig voneinander ausgewählt aus der Gruppe bestehend aus Alkyl, Alkoxy, Aryl, und Heteroaryl, und/oder wobei mindestens U oder V der Formel IIc und IId CR₁₈ ist mit R₁₈ ausgewählt aus der Gruppe bestehend aus Alkyl, Alkoxy, Aryl, und Heteroaryl, oder T, U, V und W der Formel IIc und IId unabhängig voneinander CH oder CR₁₈ sind mit R₁₈ Alkyl, bevorzugt sind T, U, V und W der Formel IIc und IId H.

In einer bevorzugten Ausführungsform der Erfindung ist mindestens ein weiterer homocyclischer oder heterocyclischer 5-Ring oder 6-Ring an U, V, W der Formel IIa oder IIb oder an T, U, V, W der Formel IIc oder IId anelliert, bevorzugt ein aromatischer heterocyclischer 5-Ring oder 6-Ring oder ein aromatischer homocyclischer 6-Ring.

In einer bevorzugten Ausführungsform der Erfindung bilden X1 und/oder X2 jeweils zusammen mit R₁₁, R₁₂, R₁₃, R₁₄ oder R₁₅ einen heterocyclischen Fünf-Ring oder Sechs-Ring mit mindestens einem Heteroatom ausgewählt aus der Gruppe bestehend aus O, S und N, oder einen homocyclischen Sechs-Ring, bevorzugt einen heterocyclischen 5-Ring.

Gemäß einer Weiterbildung der Erfindung ist vorgesehen, dass Z unabhängig voneinander ausgewählt ist aus der Gruppe bestehend aus O, S, CH₂, CHR₁₁, CR₁₂R₁₃, SiHR₁₁, SiR₁₂R₁₃, NH, NR₁₄, PR₁₅, mit R₁₁, R₁₂, R₁₃, R₁₄ und R₁₅ unabhängig voneinander ausgewählt aus der Gruppe bestehend aus Alkyl, Alkoxy, bevorzugt Alkyl, oder Z unabhängig voneinander ausgewählt ist aus der Gruppe bestehend aus O, S, CH₂, CHR₁₁ oder CR₁₂R₁₃, mit R₁₁, R₁₂ und R₁₃ unabhängig voneinander ausgewählt aus der Gruppe bestehend aus Alkyl, Aryl und Heteroaryl, und/oder wobei n 1 ist.

In einer besonders bevorzugten Ausführungsform der Erfindung ist Z ausgewählt aus der Gruppe bestehend aus CH₂, CHR₁₁, CR₁₂R₁₃, mit R₁₁, R₁₂, und R₁₃ jeweils unabhängig voneinander ein Alkyl, bevorzugt Methyl, Ethyl, Propyl oder iso-Propyl.

Gemäß einer Weiterbildung der Erfindung ist vorgesehen, dass R₄ und R₅ F sind, und/oder wobei X₁ und X₂ jeweils O oder S sind.

Gemäß einer Weiterbildung der Erfindung ist vorgesehen, dass R₂ und R₃ jeweils unabhängig voneinander ausgewählt sind aus der Gruppe bestehend aus H, Alkyl, Alkoxy, Aryl und Heteroaryl, bevorzugt sind R₂ und R₃ H oder Alkyl, insbesondere bevorzugt H, Methyl, Ethyl, oder Propyl.

Gemäß einer Weiterbildung der Erfindung ist vorgesehen, dass Z ausgewählt ist aus CH₂, CHR₁₁, und CR₁₂R₁₃ mit R₁₁, R₁₂ und R₁₃ unabhängig voneinander ausgewählt aus der Gruppe bestehend aus Alkyl, Alkoxy, Aryl und Heteroaryl, bevorzugt H oder Alkyl, und/oder wobei n 1 ist.

In einer alternativ bevorzugten Ausführungsform der Erfindung sind die Ringe der Formeln IIa, IIb, IIc und IId nicht weiter anelliert.

In einer bevorzugten Ausführungsform der Erfindung ist die chemische Verbindung spiegelsymmetrisch gegenüber der Achse durch R₁ und B gebildet.

Gemäß einer Weiterbildung der Erfindung ist vorgesehen, dass die chemische Verbindung ausgewählt ist aus der Gruppe bestehend aus

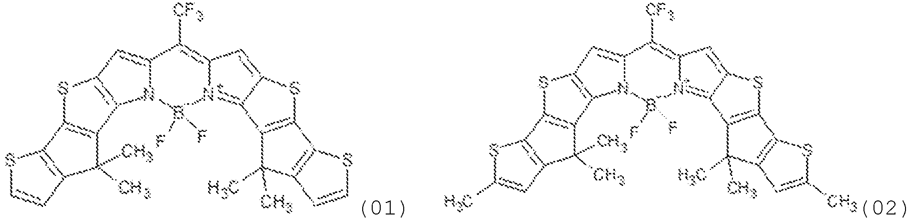

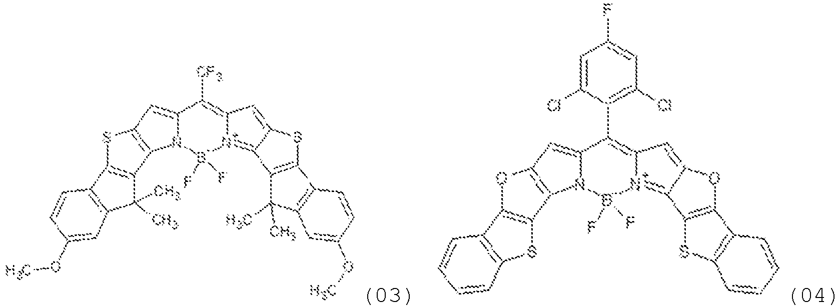

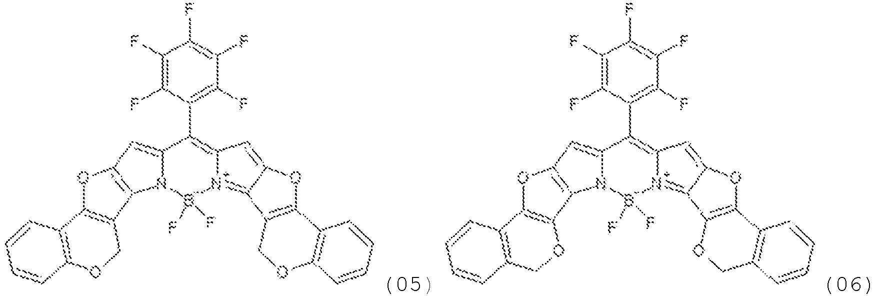

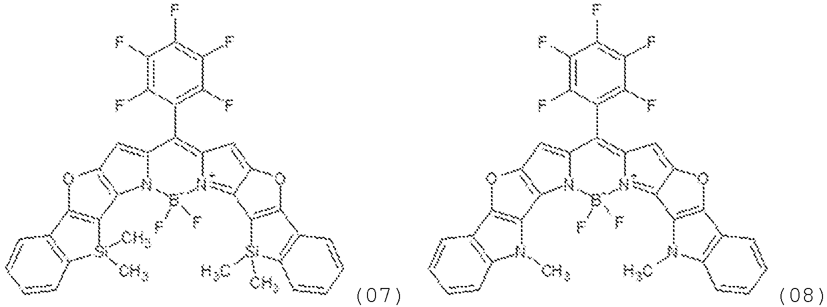

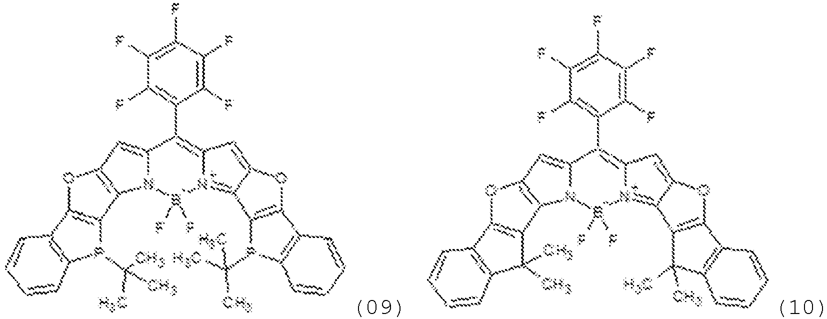

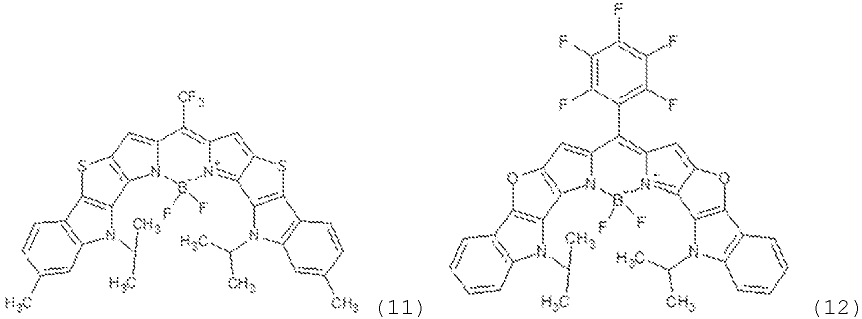

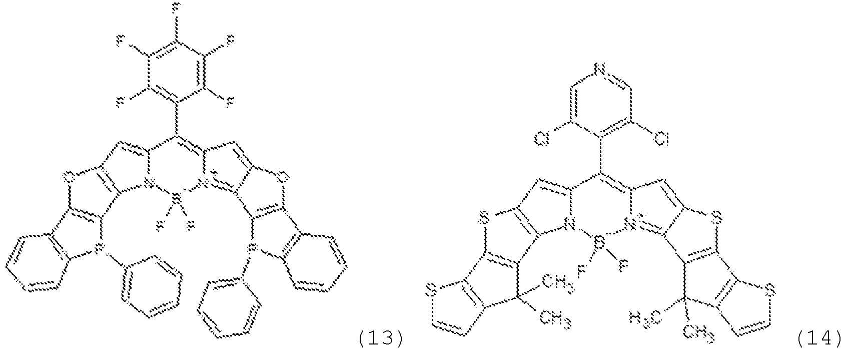

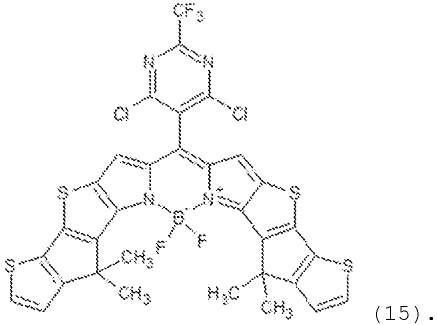

Die erfindungsgemäßen chemischen Verbindungen betreffen insbesondere sogenannte kleine Moleküle. Unter kleinen Molekülen werden insbesondere nicht-polymere organische Moleküle mit monodispersen molaren Massen zwischen 100 und 2000 g/mol verstanden, die unter Normaldruck (Luftdruck der uns umgebenden Atmosphäre) und bei Raumtemperatur in fester Phase vorliegen. Insbesondere sind die kleinen Moleküle photoaktiv, wobei unter photoaktiv verstanden wird, dass die Moleküle unter Lichteintrag ihren Ladungszustand und/oder ihren Polarisierungszustand ändern. Die photoaktiven Moleküle zeigen insbesondere eine Absorption elektromagnetischer Strahlung in einem bestimmten Wellenlängenbereich, wobei absorbierte elektromagnetische Strahlung, also Photonen, in Exzitonen umgewandelt werden. In einer bevorzugten Ausführungsform der Erfindung weist die chemische Verbindung ein Molgewicht von 300-1500 g/mol auf.

Die Aufgabe der vorliegenden Erfindung wird auch gelöst, indem ein optoelektronisches Bauelement umfassend eine erste Elektrode, eine zweite Elektrode und ein Schichtsystem, wobei das Schichtsystem zwischen der ersten Elektrode und der zweiten Elektrode angeordnet ist, bereitgestellt wird, insbesondere nach einem der zuvor beschriebenen Ausführungsbeispiele. In dem optoelektronischen Bauelement weist mindestens eine Schicht des Schichtsystems mindestens eine erfindungsgemäße chemische Verbindung auf. Dabei ergeben sich für das optoelektronische Bauelement mit der mindestens einen chemischen Verbindung insbesondere die Vorteile, die bereits in Zusammenhang mit der erfindungsgemäßen chemischen Verbindung erläutert wurden.

Gemäß einer Weiterbildung der Erfindung ist vorgesehen, dass das optoelektronische Bauelement ein Schichtsystem mit mindestens einer photoaktiven Schicht aufweist, bevorzugt eine lichtabsorbierende photoaktive Schicht, wobei die mindestens eine photoaktive Schicht, die mindestens eine chemische Verbindung aufweist.

In einer bevorzugten Ausführungsform der Erfindung ist die mindestens eine photoaktive Schicht eine Absorberschicht, bevorzugt ist die mindestens eine chemische Verbindung ein Absorbermaterial, insbesondere bevorzugt ein Donor.

In einer bevorzugten Ausführungsform der Erfindung weist das Schichtsystem mindestens zwei photoaktive Schichten, bevorzugt mindestens drei photoaktive Schichten, oder bevorzugt mindestens vier photoaktive Schichten auf.

Gemäß einer Weiterbildung der Erfindung ist vorgesehen, dass das optoelektronische Bauelement ein organisches photovoltaisches Element, ein OFET (organischer Feldeffekttransistor), eine OLED (organic light emitting diode), oder ein organischer Photodetektor ist. Ein organisches photovoltaisches Element ermöglicht es elektromagnetische Strahlung, insbesondere im Wellenlängenbereich des sichtbaren Lichts, unter Ausnutzung des photoelektrischen Effekts in elektrischen Strom umzuwandeln. In diesem Sinne wird der Begriff "photoaktiv" als Umwandlung von Lichtenergie in elektrische Energie verstanden.

Die Aufgabe der vorliegenden Erfindung wird auch gelöst, indem eine Verwendung einer erfindungsgemäßen chemischen Verbindung in einem optoelektronischen Bauelement bereitgestellt wird, insbesondere nach einem der zuvor beschriebenen Ausführungsbeispiele. Dabei ergeben sich für die Verwendung der chemischen Verbindung in einem optoelektronischen Bauelement insbesondere die Vorteile, die bereits in Zusammenhang mit der erfindungsgemäßen chemischen Verbindung und dem optoelektronischen Bauelement mit der mindestens einer chemischen Verbindung erläutert wurden.

Gemäß einer Weiterbildung der Erfindung wird die erfindungsgemäße chemische Verbindung in einem organischen photovoltaischen Element, einem OFET (organischer Feldeffekttransistor), einer OLED (organic light emitting diode), oder einem organischen Photodetektor verwendet.

In einer bevorzugten Ausführungsform der Erfindung wird die mindestens eine erfindungsgemäße chemische Verbindung als Absorbermaterial in einer photoaktiven Schicht des optoelektronischen Bauelements verwendet. In einer bevorzugten Ausführungsform der Erfindung wird die erfindungsgemäße chemische Verbindung als Donor in einem Donor-Akzeptor-Heteroübergang verwendet.

In einer bevorzugten Ausführungsform der Erfindung weist das Schichtsystem des optoelektronischen Bauelements mindestens eine Transportschicht auf, wobei die mindestens eine Transportschicht dotiert, teilweise dotiert oder undotiert ist, bevorzugt weist das Schichtsystem mindestens eine Elektronentransportschicht (ETL) und mindestens eine Lochtransportschicht (HTL) auf.

In einer bevorzugten Ausführungsform der Erfindung ist die Verbindung und/oder eine Schicht mit der mindestens einen chemischen Verbindung mittels Vakuumprozessierung, Gasphasenabscheidung oder Lösungsmittel-Prozessierung abgeschieden, insbesondere bevorzugt mittels Vakuumprozessierung.

Die Erfindung wird im Folgenden anhand der Zeichnungen näher erläutert. Dabei zeigen:
Fig. 1 eine schematische Darstellung eines Ausführungsbeispiels eines optoelektronischen Bauelements im Querschnitt;
Fig. 2 eine grafische Darstellung von Absorptionsspektren erfindungsgemäßer und nicht erfindungsgemäßer Verbindungen;
Fig. 3 eine grafische Darstellung der Strom-Spannungskurve, der spektralen externen Quantenausbeute und des Füllfaktors einer BHJ-Zelle mit der Verbindung (02), gemessen an einem organischen optoelektronischen Bauelement;
Fig. 4 eine grafische Darstellung der Strom-Spannungskurve, der spektralen externen Quantenausbeute und des Füllfaktors einer BHJ-Zelle mit der Verbindung (03), gemessen an einem organischen optoelektronischen Bauelement;
Fig. 5 eine grafische Darstellung der Strom-Spannungskurve, der spektralen externen Quantenausbeute und des Füllfaktors einer BHJ-Zelle mit der Verbindung (12), gemessen an einem organischen optoelektronischen Bauelement; und
Fig. 6 eine grafische Darstellung der Strom-Spannungskurve, der spektralen externen Quantenausbeute und des Füllfaktors einer PHJ-Zelle mit der Verbindung (12), gemessen an einem organischen optoelektronischen Bauelement.

### Ausführungsbeispiele

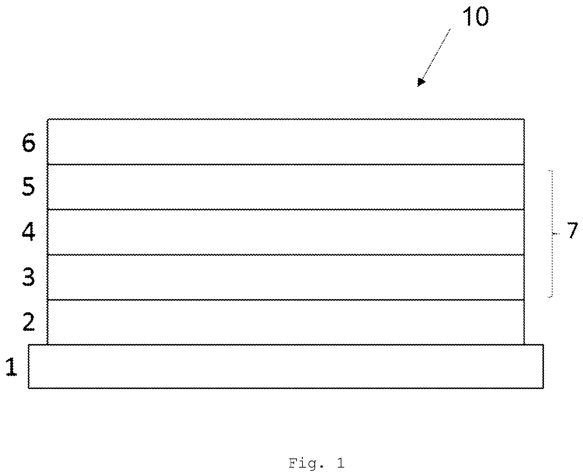

Fig. 1 zeigt eine schematische Darstellung eines Ausführungsbeispiels eines optoelektronischen Bauelements im Querschnitt. Das optoelektronische Bauelement 10 weist dabei mindestens eine chemische Verbindung der allgemeinen Formel Ia oder Ib auf.

Das optoelektronische Bauelement 10 umfasst eine erste Elektrode 2, eine zweite Elektrode 6 und ein Schichtsystem 7, wobei das Schichtsystem 7 zwischen der ersten Elektrode 2 und der zweiten Elektrode 6 angeordnet ist. Dabei weist mindestens eine Schicht des Schichtsystems 7 mindestens eine erfindungsgemäße chemische Verbindung auf.

In einer Ausgestaltung der Erfindung weist das optoelektronische Bauelement 10 ein Schichtsystem 7 mit mindestens einer photoaktiven Schicht 4 auf, bevorzugt eine lichtabsorbierende photoaktive Schicht 4, wobei die mindestens eine photoaktive Schicht 4 die mindestens eine chemische Verbindung aufweist. Das optoelektronische Bauelement 10 kann ein organisches photovoltaisches Element, ein OFET (organischer Feldeffekttransistor), eine OLED (organic light emitting diode), oder ein organischer Photodetektor sein. In diesem Ausführungsbeispiel ist das optoelektronische Bauelement 10 ein organisches photovoltaisches Element.

In diesem Ausführungsbeispiel weist das organische photovoltaische Element ein Schichtsystem 7 mit mindestens einer photoaktiven Schicht 4 auf, bevorzugt eine lichtabsorbierende photoaktive Schicht 4, wobei die mindestens eine photoaktive Schicht 4 die mindestens eine erfindungsgemäße Verbindung aufweist.

In einem Ausführungsbeispiel weist das organische photovoltaische Element ein Substrat 1 auf, z.B. aus Glas, auf dem sich eine Elektrode 2 befindet, z.B. aus ITO. Darauf angeordnet ist das Schichtsystem 7 mit einer elektronentransportierenden Schicht 3 (ETL) sowie einer photoaktiven Schicht 4 mit mindestens einer erfindungsgemäßen Verbindung als p-leitenden Donor-Material, und einem n-leitenden Akzeptor-Material, z. B. C60 Fulleren. Die photoaktive Schicht 4 kann entweder als flacher Heteroübergang (planar heterojunction - PHJ) oder als Volumen-Heteroübergang (bulk heterojunction - BHJ) ausgebildet sein. Darüber angeordnet befindet sich eine p-dotierte Lochtransportschicht 5 (HTL), und eine Elektrode 6 aus Gold oder Aluminium.

In einer weiteren Ausgestaltung der Erfindung ist die photoaktive Schicht 4 als Mischschicht aus der mindestens einen erfindungsgemäßen Verbindung und mindestens einer weiteren Verbindung, oder als Mischschicht der mindestens einen erfindungsgemäßen Verbindung und mindestens zwei weiteren Verbindungen ausgebildet, wobei die Verbindungen Absorbermaterialien sind.

In einer weiteren Ausgestaltung der Erfindung weist das Schichtsystem 7 mindestens zwei photoaktive Schichten 4 auf, bevorzugt mindestens drei photoaktive Schichten 4, oder bevorzugt mindestens vier photoaktive Schichten 4.

In einer weiteren Ausgestaltung der Erfindung ist das optoelektronische Bauelement 10 als Tandemzelle, Tripelzelle oder Mehrfachzelle ausgebildet. Dabei sind zwei oder mehr photoaktive Schichten 4 übereinandergestapelt, wobei die photoaktiven Schichten 4 aus gleichen oder unterschiedlichen Materialien oder Materialmischungen aufgebaut sind.

Die Herstellung der einzelnen eines erfindungsgemäßen optoelektronischen Bauelements 10 kann durch Verdampfen im Vakuum, mit oder ohne Trägergas oder Prozessieren einer Lösung oder Suspension, wie zum Beispiel beim Coaten oder Drucken geschehen. Einzelne Schichten können ebenso durch Sputtern aufgetragen werden. Dies ist vor allem für den Grundkontakt möglich. Vorteilhaft ist die Herstellung der Schichten durch Verdampfen im Vakuum, wobei das Trägersubstrat erwärmt sein kann.

Die allgemeine Herstellung der erfindungsgemäßen Verbindungen ist dem Fachmann aus dem Stand der Technik bekannt. In diesem Zusammenhang wird insbesondere auf die internationalen Anmeldungen WO2007/126052A1 verwiesen.

Die chemische Verbindung der allgemeinen Formel Ia oder Ib weist folgende Struktur auf: 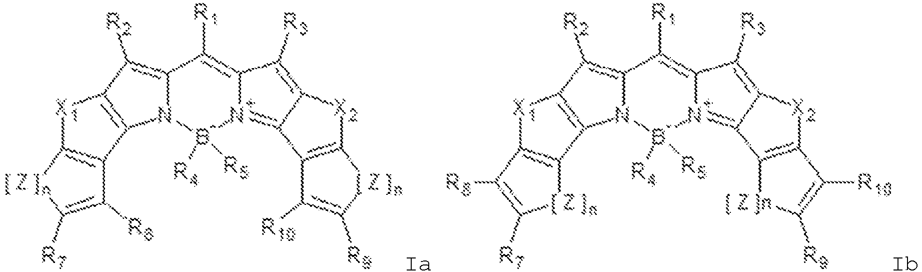 wobei X₁ und X₂ unabhängig voneinander O, S, oder NR₆ sind, mit R₆ ausgewählt aus der Gruppe bestehend aus H, Alkyl, Alkoxy, Amino, Aryl, und Heteroaryl, R₁ ausgewählt ist aus der Gruppe bestehend aus F, fluoriertem oder teilfluoriertem Alkyl, und einem aromatischen heterocyclischen 5-Ring oder 6-Ring oder einem aromatischen homocyclischen 6-Ring, R₂ und R₃ jeweils unabhängig voneinander ausgewählt sind aus der Gruppe bestehend aus H, Halogen, CN, Alkyl, Alkoxy, Amino, Aryl und Heteroaryl, R₄ und R₅ jeweils unabhängig voneinander ausgewählt sind aus der Gruppe bestehend aus Halogen, bevorzugt F, und fluoriertem oder teilfluoriertem Alkyl, mit Z unabhängig voneinander ausgewählt aus der Gruppe bestehend aus O, S, CH₂, CHR₁₁, CR₁₂R₁₃, SiHR₁₁, SiR₁₂R₁₃, NH, NR₁₄, PR₁₅, mit R₁₁, R₁₂, R₁₃, R₁₄ und R₁₅ unabhängig voneinander ausgewählt aus der Gruppe bestehend aus Halogen, Alkyl, Alkoxy, Amino, Aryl, und Heteroaryl, mit n unabhängig voneinander 1 oder 2, wobei R₇ und R₈ und/oder R₉ und R₁₀ jeweils zusammen einen heterocyclischen 5-Ring oder 6-Ring mit mindestens einem Heteroatom ausgewählt aus der Gruppe bestehend aus O, S, N, Si oder P, oder einen homocyclischen 6-Ring bilden, wobei der heterocyclische 5-Ring oder 6-Ring oder der homocyclische 6-Ring jeweils weiter anelliert sein kann.

In einer Ausgestaltung der Erfindung ist R₁ ausgewählt aus der Gruppe bestehend aus F, CF₃, C₂F₅, und einem aromatischen heterocyclischen 5-Ring oder 6-Ring oder einem aromatischen homocyclischen 6-Ring, wobei bevorzugt mindestens ein H-Atom durch F, Cl und/oder CF₃ substituiert ist, bevorzugt einem aromatischen heterocyclischen 6-Ring oder einem aromatischen homocyclischen 6-Ring, wobei mindestens zwei H-Atome, durch F, Cl und/oder CF₃ substituiert sind.

In einer weiteren Ausgestaltung der Erfindung bilden R₇ und R₈ und/oder R₉ und R₁₀ jeweils zusammen einen aromatischen homocyclischen 6-Ring, wobei bevorzugt mindestens ein H-Atom des homocyclischen 6-Rings durch Halogen, Alkyl, Alkoxy, Aryl oder Heteroaryl substituiert ist, und/oder ist der homocyclische 6-Ring nicht weiter anelliert.

In einer weiteren Ausgestaltung der Erfindung bilden R₇ und R₈ und/oder R₉ und R₁₀ jeweils zusammen einen aromatischen heterocyclischen 5-Ring oder 6-Ring mit mindestens einem Heteroatom ausgewählt aus der Gruppe bestehend aus O, S, N, Si oder P, wobei bevorzugt mindestens ein H-Atom des heterocyclischen 5-Rings oder 6-Rings durch Halogen, Alkyl, Alkoxy, Aryl oder Heteroaryl substituiert ist, und/oder der heterocyclische 5-Ring oder 6-Ring nicht weiter anelliert ist.

In einer weiteren Ausgestaltung der Erfindung ist R₂ gleich R₃ ist, R₄ gleich R₅, und/oder sind R₇ und R₈ gleich R₉ und R₁₀.

In einer weiteren Ausgestaltung der Erfindung weist die chemische Verbindung die allgemeine Formel IIa, IIb, IIc und/oder IId auf 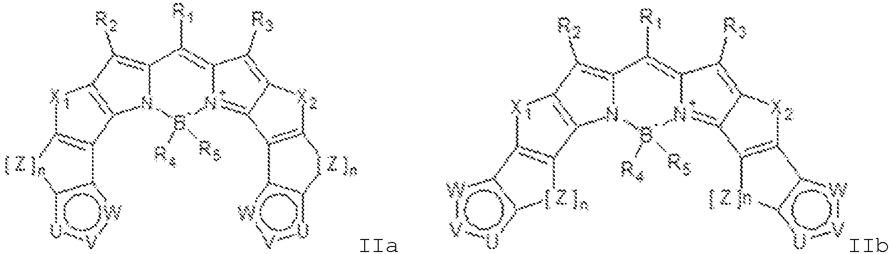 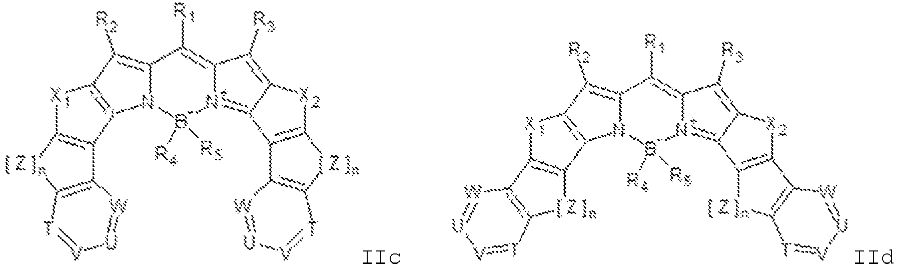 mit U, V und W der Formel IIa und IIb unabhängig voneinander ausgewählt aus der Gruppe bestehend aus CR₁₆, O, S, N, NR₁₇ mit R₁₆ und R₁₇ unabhängig voneinander ausgewählt aus der Gruppe bestehend aus H, Halogen, Alkyl, Alkoxy, Alkylthiooxy, Amino, Aryl, und Heteroaryl, mit T, U, V und W der Formel IIc und IId unabhängig voneinander ausgewählt aus der Gruppe bestehend aus CH, CR₁₈ und N mit R₁₈ unabhängig voneinander ausgewählt aus der Gruppe bestehend aus Halogen, Alkyl, Alkoxy, Alkylthiooxy, Amino, Aryl, und Heteroaryl, wobei an U, V und W der Formel IIa und IIb oder an T,

U, V und W der Formel IIc und IId ein heterocyclischer 5-Ring oder 6-Ring mit mindestens einem Heteroatom ausgewählt aus der Gruppe bestehend aus O, S, und N oder ein homocyclischer 6-Ring anelliert sein kann, mit Z unabhängig voneinander ausgewählt aus der Gruppe bestehend aus O, S, CH₂, CHR₁₁, CR₁₂R₁₃, SiHR₁₁, SiR₁₂R₁₃, NH, NR₁₄, PR₁₅, mit R_{11,} R₁₂, R₁₃, R₁₄ und R₁₅ unabhängig voneinander ausgewählt aus der Gruppe bestehend aus Alkyl, Alkoxy, Amino, Aryl, und Heteroaryl, und mit n unabhängig voneinander 1 oder 2.

In einer weiteren Ausgestaltung der Erfindung ist mindestens ein U, V, und W der Formel IIa und IIb ein O oder S ist, bevorzugt U oder W, sind T, U, V und W der Formel IIc und IId unabhängig voneinander ausgewählt aus der Gruppe bestehend aus CH und CR₁₈ mit R₁₈ unabhängig voneinander ausgewählt aus der Gruppe bestehend aus Alkyl, Alkoxy, Aryl, und Heteroaryl, und/oder
ist mindestens U oder V der Formel IIc und IId CR₁₈ mit R₁₈ ausgewählt aus der Gruppe bestehend aus Alkyl, Alkoxy, Aryl, und Heteroaryl, oder sind T, U, V und W der Formel IIc und IId unabhängig voneinander CH oder CR₁₈ mit R₁₈ Alkyl, bevorzugt sind T, U, V und W der Formel IIc und IId H.

In einer weiteren Ausgestaltung der Erfindung ist Z unabhängig voneinander ausgewählt aus der Gruppe bestehend aus O, S, CH₂, CHR₁₁, CR₁₂R₁₃, SiHR₁₁, SiR₁₂R₁₃, NH, NR₁₄, PR₁₅, mit R₁₁, R₁₂, R₁₃, R₁₄ und R₁₅ unabhängig voneinander ausgewählt aus der Gruppe bestehend aus Alkyl, Alkoxy, bevorzugt Alkyl, oder ist Z unabhängig voneinander ausgewählt aus der Gruppe bestehend aus O, S, CH₂, CHR₁₁ oder CR₁₂R₁₃, mit R₁₁, R₁₂ und R₁₃ unabhängig voneinander ausgewählt aus der Gruppe bestehend aus Alkyl, Aryl und Heteroaryl, und/oder ist n 1.

In einer weiteren Ausgestaltung der Erfindung sind R₄ und R₅ F, und/oder sind X₁ und X₂ jeweils O oder S.

In einer weiteren Ausgestaltung der Erfindung sind R₂ und R₃ jeweils unabhängig voneinander ausgewählt aus der Gruppe bestehend aus H, Alkyl, Alkoxy, Aryl und Heteroaryl, bevorzugt sind R₂ und R₃ H oder Alkyl, insbesondere bevorzugt H, Methyl, Ethyl, oder Propyl.

In einer weiteren Ausgestaltung der Erfindung ist Z ausgewählt aus CH₂, CHR₁₁, und CR₁₂R₁₃ mit R₁₁, R₁₂ und R₁₃ unabhängig voneinander ausgewählt sind aus der Gruppe bestehend aus Alkyl, Alkoxy, Aryl und Heteroaryl, bevorzugt H oder Alkyl, und/oder ist n 1.

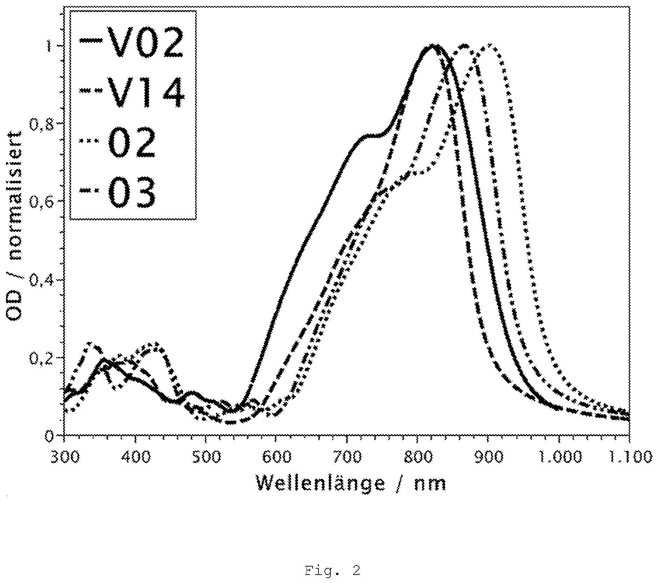

Fig. 2 zeigt eine grafische Darstellung von Absorptionsspektren erfindungsgemäßer und nicht-erfindungsgemäßer Verbindungen.

Die Absorptionsspektren der erfindungsgemäßen Verbindungen (2), (3) und (12) werden mit denen der nicht-erfindungsgemäßen Verbindungen V02 und V14 verglichen. Die Absorptionsspektren (optische Dichte über Wellenlänge in nm) der Verbindungen wurde jeweils für 30 nm dicke vakuumaufgedampfte Schichten auf Quarzglas und in einer Lösung aus Dichlormethan gemessen.

Die verbrückten Verbindungen (2), (3) und (12) zeigen eine in den roten Spektralbereich des sichtbaren Lichts verschobenen Absorptionsbereich im Vergleich zu den unverbrückten Verbindungen V02 und V14.

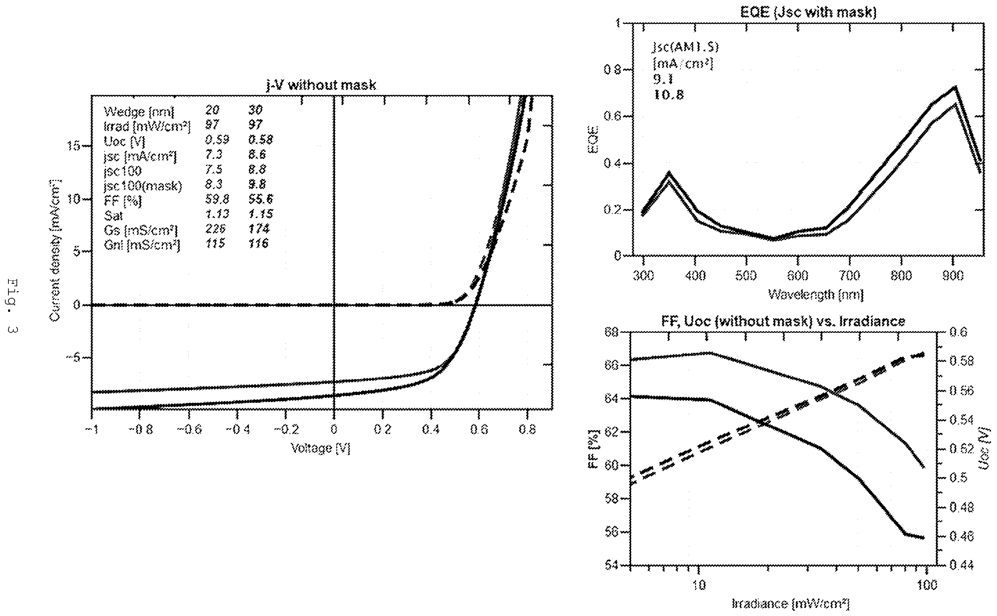

In den folgenden Figuren 3 bis 6 werden konkrete Ausführungsbeispiele von organischen photovoltaischen Elementen mit erfindungsgemäßen chemischen Verbindungen der allgemeinen Formel I aufgezeigt.

Fig. 3 zeigt eine grafische Darstellung der Strom-Spannungskurve, der spektralen externen Quantenausbeute und des Füllfaktors einer BHJ-Zelle mit der Verbindung (02), gemessen an einem organischen optoelektronischen Bauelement 10. In diesem Ausführungsbeispiel ist das optoelektronische Bauelement 10 ein organisches photovoltaisches Element.

Die Strom-Spannungskurve enthält Kennzahlen, die das organische photovoltaische Element kennzeichnen. Die wichtigsten Kennzahlen sind hierbei der Füllfaktor FF, die Leerlaufspannung Uoc und der Kurzschlussstrom Jsc.

Zur Untersuchung der Verbindungen, also deren Einsatz als Absorbermaterialien in organischen photovoltaischen Elementen, wurde die Strom-Spannungskurve einer BHJ-Zelle gemessen. In diesem Ausführungsbeispiel weist die BHJ-Zelle auf der ITO-Schicht eine Schicht von C60 3 mit einer Schichtdicke von 15 nm auf. Auf diese Schicht wurde die Verbindung (02) zusammen mit C60 in einer Dicke von 30 nm im molaren Verhältnis 2:3 bei 90°C als photoaktive Schicht 4 aufgetragen. Dieser Schicht folgt eine Schicht aus BF-DBP in einer Schichtdicke von 10 nm gefolgt von einer Schicht umfassend BF-DBP mit 4,1 Gew.-% NDP9 in einer Schichtdicke von 45 nm als Lochtransportschicht 5. An diese Schicht schließt sich eine weitere Schicht mit NDP9 in einer Dicke von 1 nm an, worauf eine Gold-Schicht in einer Dicke von 50 nm folgt. ITO dient dabei als Elektrode 2, und das benachbarte Fulleren C60 als Elektronentransportschicht (ETL) 3, daran schließt sich die photoaktive Schicht 4 mit C60 als Elektronenakzeptormaterial und dem jeweiligen Absorber an, gefolgt von BF-DBP als Lochtransportschicht (HTL) 5 und mit NDP9 (Novaled AG) dotiertem BF-DBP, gefolgt von einer Elektrode 6 aus Gold.

Die Strom-Spannungskurve einer BHJ-Zelle mit dem Aufbau: ITO / C60 (15 nm) / Verbindung(02):C60 (30nm, 3:2, 90°C) / BF-DBP (10nm) / BF-DBP:NDP9 (45nm, 4,1 wt% NDP9) / NDP9 (1nm) / Au (50nm) wurde bestimmt. Die Parameter der Zelle wurden unter AM1.5 Beleuchtung gemessen (AM = Air Mass; AM = 1,5 bei diesem Spektrum beträgt die globale Strahlungsleistung 1000 W/m²; AM = 1,5 als Standardwert für die Vermessung von Solarmodulen), wobei die photoaktive Schicht 4 ein Volumenheteroübergang (bulk heterojunction - BHJ) umfasst.

In dem organischen photovoltaischen Element mit Verbindung (02) beträgt der Füllfaktor FF 55,6 %, die Leerlaufspannung Uoc 0,58 V und der Kurzschlussstrom Jsc 10,8 mA/cm². Der Zellwirkungsgrad eines solchen optoelektronischen Bauelements 10, insbesondere ein photovoltaisches Element, mit der Verbindung (02) beträgt 3,48%. Die Verbindung (02) zeigt eine gute Verdampfbarkeit im Vakuum.

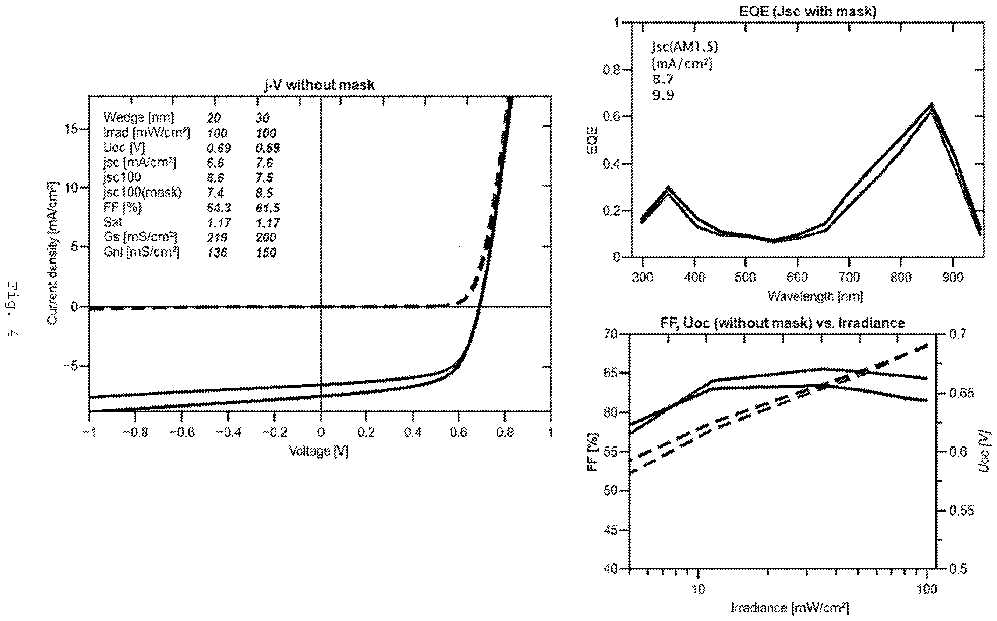

Fig. 4 zeigt eine grafische Darstellung der Strom-Spannungskurve, der spektralen externen Quantenausbeute und des Füllfaktors einer BHJ-Zelle mit der Verbindung (03), gemessen an einem organischen optoelektronischen Bauelement 10. In diesem Ausführungsbeispiel ist das optoelektronische Bauelement 10 ein organisches photovoltaisches Element. Der Aufbau der BHJ-Zelle entspricht dem Aufbau der Zelle aus Fig. 3, wobei als Donor der photoaktiven Schicht 4 die Verbindung (03) eingesetzt wurde.

In dem organischen photovoltaischen Element mit Verbindung (03) beträgt der Füllfaktor FF 61,5 %, die Leerlaufspannung Uoc 0,69 V und der Kurzschlussstrom Jsc 9,9 mA/cm². Der Zellwirkungsgrad eines solchen optoelektronischen Bauelements 10, insbesondere ein photovoltaisches Element, mit der Verbindung (03) beträgt 4,20%. Die Verbindung (03) zeigt eine gute Verdampfbarkeit im Vakuum.

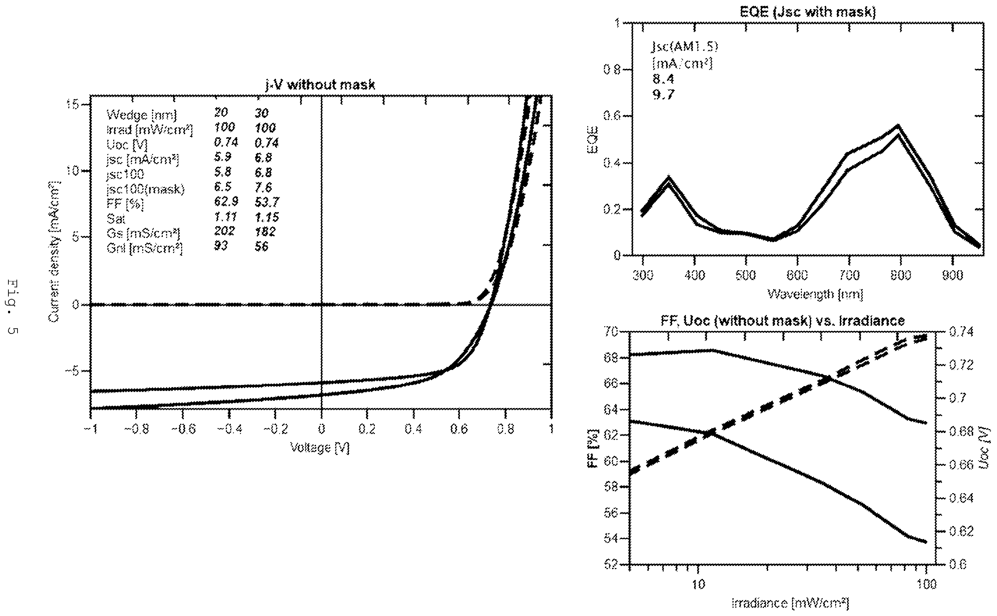

Fig. 5 zeigt eine grafische Darstellung der Strom-Spannungskurve, der spektralen externen Quantenausbeute und des Füllfaktors einer BHJ-Zelle mit der Verbindung (12), gemessen an einem organischen optoelektronischen Bauelement 10. In diesem Ausführungsbeispiel ist das optoelektronische Bauelement 10 ein organisches photovoltaisches Element. Der Aufbau der BHJ-Zelle entspricht dem Aufbau der Zelle aus Fig. 3, wobei als Donor der photoaktiven Schicht 4 die Verbindung (12) eingesetzt wurde.

In dem organischen photovoltaischen Element mit Verbindung (12) beträgt der Füllfaktor FF 53,7 %, die Leerlaufspannung Uoc 0,74 V und der Kurzschlussstrom Jsc 9,7 mA/cm². Der Zellwirkungsgrad eines solchen optoelektronischen Bauelements 10, insbesondere ein photovoltaisches Element, mit der Verbindung (12) beträgt 3,85%. Die Verbindung (12) zeigt eine gute Verdampfbarkeit im Vakuum.

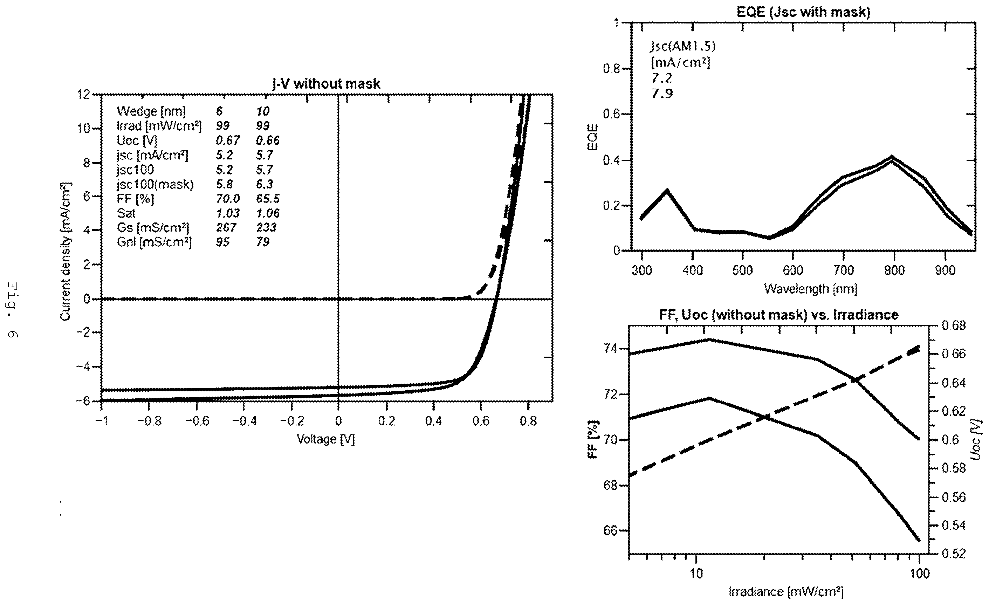

Fig. 6 zeigt eine grafische Darstellung der Strom-Spannungskurve, der spektralen externen Quantenausbeute und des Füllfaktors einer PHJ-Zelle mit der Verbindung (12), gemessen an einem organischen optoelektronischen Bauelement 10. In diesem Ausführungsbeispiel ist das optoelektronische Bauelement 10 ein organisches photovoltaisches Element.

Die Strom-Spannungskurve einer PHJ-Zelle mit dem Aufbau: ITO / C60 (15 nm) / Verbindung(12) (6nm, 20°C) / BF-DBP (10nm) / BF-DBP:NDP9 (45nm, 4wt% NDP9) / NDP9 (1nm) / Au (50nm) wurde bestimmt, wobei die photoaktive Schicht 4 einen planaren Heteroübergang (planar heterojunction - PHJ) umfasst.

In dem organischen photovoltaischen Element mit Verbindung (12) beträgt der Füllfaktor FF 70,0 %, die Leerlaufspannung Uoc 0,67 V und der Kurzschlussstrom Jsc 7,2 mA/cm². Der Zellwirkungsgrad eines solchen optoelektronischen Bauelements 10, insbesondere ein photovoltaisches Element, mit der Verbindung (12) beträgt 3,38%.

Die vorteilhaften Eigenschaften der erfindungsgemäßen chemischen Verbindungen zeigen sich insbesondere in den Absorptionseigenschaften, insbesondere im Vergleich zu nicht-erfindungsgemäßen Verbindungen, die unverbrückt sind. In Tabelle 1 sind die Absorptionsmaxima und die Steilheit der Verbindungen (01) bis (15) im Vergleich mit den nicht-erfindungsgemäßen Verbindungen V02, V03, V05 und V14 in Lösung und im Film zusammengefasst.

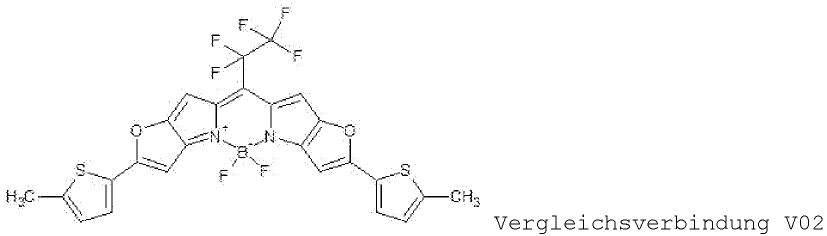

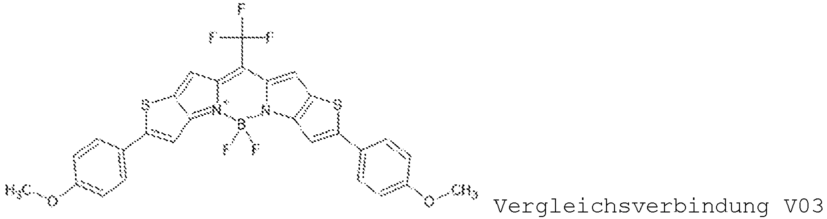

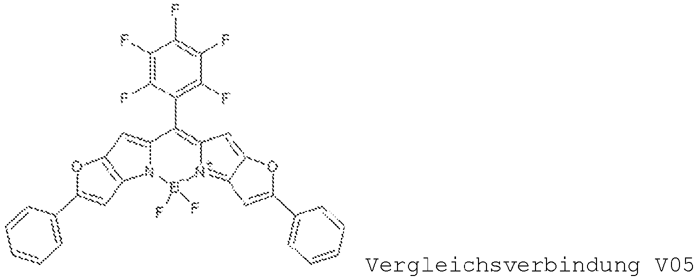

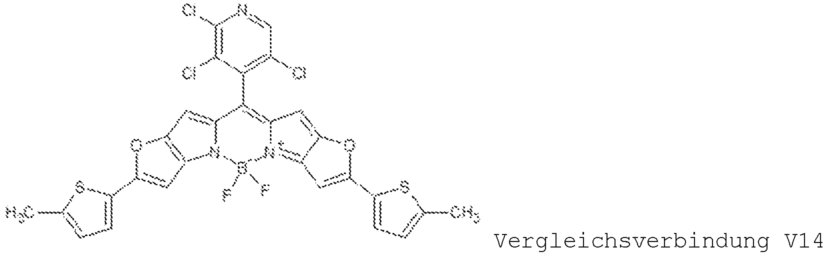

**Tabelle 1**

| **Verbindung** | **Absorptionsmaximum [nm] in Lösung** | **Absorptionsmaximum [nm] im Film** | **Steilheit [1/eV]** |
|---|---|---|---|
| 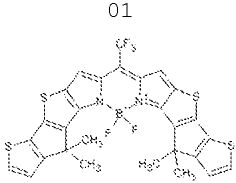 | 785 | 874 | 11,96 |
| 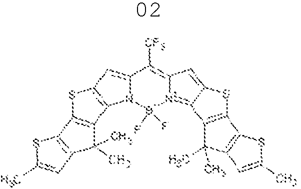 | 809 | 900 | 11,58 |
| 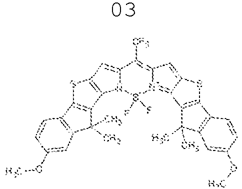 | 776 | 865 | 10,05 |
| 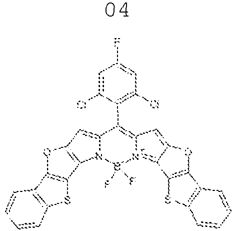 | 681 | 780 | 9,54 |
| 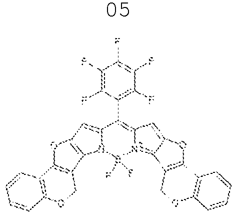 | | | |
| 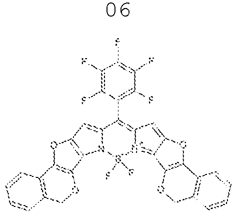 | | | |
| 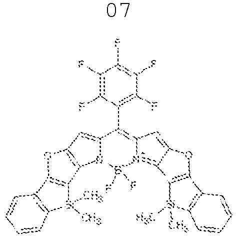 | | | |
| 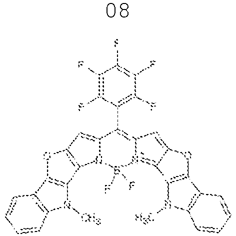 | | | |
| 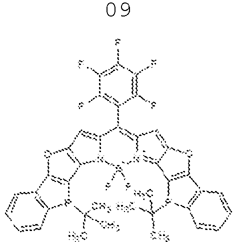 | | | |
| 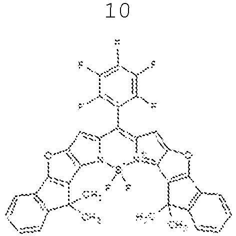 | | | |
| 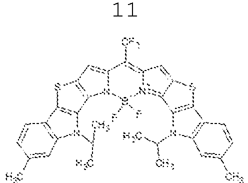 | | | |
| 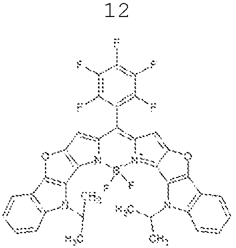 | 733 | 789 | 9, 53 |
| 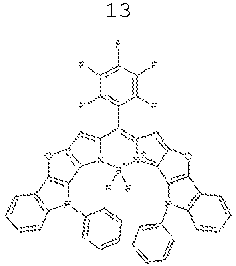 | | | |
| 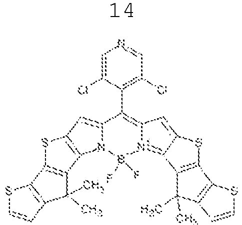 | 749 | 827 | 13,91 |
| 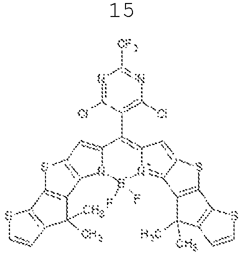 | 764 | 838 | 13,05 |
| V02 | | 822 | 6, 96 |
| V03 | | 809 | 5,11 |
| V05 | | 741 | 9, 14 |
| V14 | | 817 | 9, 64 |

Zur Bestimmung der Steilheit wird die Tangente im Wendepunkt der langwelligen Absorptionskante bestimmt. Die Steilheit ergibt sich als Kehrwert der Differenz aus Abszisse des Wendepunkts in eV und der Nullstelle der Tangente in eV.

Die optischen Eigenschaften wurden experimentell bestimmt. Die Absorptionsmaxima λmax wurden in einer Küvette mit Dichlormethan und aus 30nm dicken Vakuumaufdampfschichten auf Quarzglas mittels eines Photometers bestimmt. Überraschenderweise wurde gefunden, dass die chemischen Verbindungen (01) bis (15) im Film ein besonders weit in den nahinfraroten Spektralbereich verschobenes Absorptionsmaximum aufweisen, insbesondere oberhalb von 750 nm, bevorzugt oberhalb von 780 nm, insbesondere bevorzugt oberhalb von 800 nm. Des Weiteren weisen die verbrückten chemischen Verbindungen (01) bis (15) eine besonderes steile Absorptionskante im Vergleich zu der jeweils entsprechenden unverbrückten Verbindung auf.

So zeigt die Cyclopentadien-verbrückte Verbindung (02) mit 11,58 e/V eine steilere Absorptionskante im Vergleich zur Verbindung V02 mit 6,96 e/V. Die Cyclopentadien-verbrückte Verbindung (03) zeigt mit 10,05 e/V eine steilere Absorptionskante im Vergleich zur Verbindung V03 mit 5,11 e/V. Des Weiteren zeigen die Pyridinverbrückten Verbindungen (08), (11) und (12), die Pyran-verbrückten Verbindungen (05) und (06), und die Cyclopentadien-verbrückte Verbindung (10) steilere Absorptionskanten im Vergleich zur Verbindung V05.

Tabelle 2 zeigt die photovoltaischen Parameter Voc, Jsc und FF der erfindungsgemäßen Verbindungen (01) bis (15). Die Zellen haben folgenden Aufbau:
BHJ-Zelle: Glas mit ITO / C60 (15nm) / Absorber:C60 (30nm, 3:2, 90°C) / BF-DBP (10nm) / BF-DBP:NDP9 (45nm, 4wt% NDP9) / NDP9 (1nm) / Au (50nm);
PHJ-Zelle: Glas mit ITO / C60 (15nm) / Absorber (6nm, 20°C) / BF-DBP (10nm) / BF-DBP:NDP9 (45nm, 4wt% NDP9) / NDP9 (1nm) / Au (50nm); und wurde unter AM1.5 Beleuchtung gemessen (AM = Air Mass;
AM = 1,5 bei diesem Spektrum beträgt die globale Strahlungsleistung 1000 W/m²; AM = 1,5 als Standardwert für die Vermessung von Solarmodulen).
BF-DBP: Lochtransportmaterial

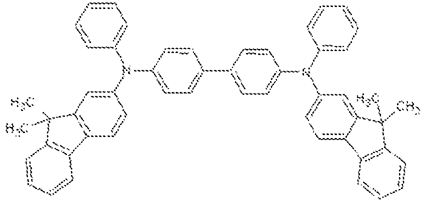

**Tabelle 2**

| **Verbindung** | **Zelltyp** | **Voc [V]** | **Jsc [mA/cm² ]** | **FF [%]** | **EQEₘₐₓ [%]** |
|---|---|---|---|---|---|
| (01) * | BHJ | 0,73 | 9, 4 | 58, 0 | |
| (02) | BHJ | 0,58 | 10,8 | 55, 6 | > 70 |
| (03) | BHJ | 0, 69 | 9, 9 | 61,5 | > 60 |
| (04) | | | | | |
| (05) | | | | | |
| (06) | | | | | |
| (07) | | | | | |
| (08) | | | | | |
| (09) | | | | | |
| (10) | | | | | |
| (11) | | | | | |
| (12) | BHJ | 0, 74 | 9,7 | 53,7 | |
| (12) | PHJ | 0, 67 | 7,2 | 70 | > 70 |
| (13) | | | | | |
| (14)* | BHJ | 0,67 | 6,6 | 39,1 | |
| (15) | BHJ | 0,70 | 9, 6 | 58, 0 | |
| V02 | | | | | |
| V03 | | | | | |
| V05 | | | | | |
| V14 | | | | | |

| | | | | | |
|---|---|---|---|---|---|
| * in den Zellen mit den Verbindungen (01) und (014) wurde statt des Lochtransportmaterial BF-DBP das Lochtransportmaterial HTM081 der Merck AG eingesetzt. | | | | | |

Es konnte zudem gezeigt werden, dass die Verbindungen (01) bis (15) eine hohe thermische Stabilität aufweisen und im Vakuum ohne Zersetzung verdampfbar sind.

Die experimentellen Daten erfindungsgemäßer chemischer Verbindungen mit den Absorptionseigenschaften der Verbindungen und den in organischen photovoltaischen Elementen gemessenen Strom-Spannungsverläufen belegen, dass die erfindungsgemäßen chemischen Verbindungen für die Anwendung in organischen photovoltaischen Elementen sowie anderen organischen optoelektronischen Bauelementen sehr gut geeignet sind.

### Synthese

Allgemeine Synthese zur Herstellung von chemischen Verbindungen der allgemeinen Formel Ia oder Ib ist aus WO2007126052A1, Bartellmess et al. ("meso-Pyridyl BODIPYs with tunable chemical, optical and electrochemical properties", New Journal of Chemistry, 37(9), 2663-2668; 2013), und Li et al. ("Small Molecule Near-Infrared Boron Dipyrromethene Donors for Organic Tandem Solar Cells", J.Am.Chem.Soc., 2017, 139, 13636-13639) bekannt.

Im Folgenden sind Ausführungsbeispiele zur Synthese erfindungsgemäßer chemischer Verbindungen dargestellt. Aus den hier gebildeten Aldehyden werden die entsprechenden BODIPYs analog Umezawa et al. (J. Am. Chem. Soc., 2008, 130, 5, 1550-1551) oder Yang et al. (Chem. Commun., 2013,49, 3940-3942) hergestellt.

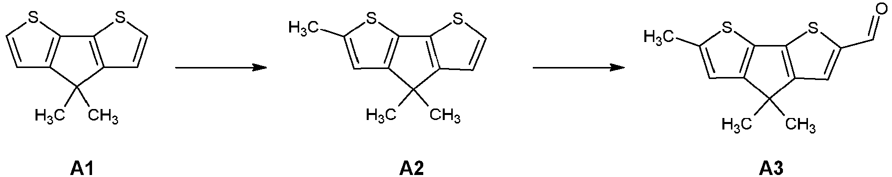

Allgemeine Vorgehensweise A2: Verbindung A1 (1 eq) wurde bei -30°C in 50 Vol. wasserfreiem THF (Tetrahydrofuran) gelöst und tropfenweise mit n-BuLi (2,5 mol/l, 1,40 eq) versetzt. Die Mischung wurde 30 min bei -30°C gerührt, mit Methyliodid (1,60 eq) versetzt und anschließend über Nacht auf 20°C erwärmt. Die Mischung wurde auf halbkonzentrierte Ammoniumchlorid-Lösung gegeben und mit Ethylacetat extrahiert. Die organische Phase wurde mit Wasser und gesättigter NaCl-Lösung gewaschen. Anschließend wurde über Natriumsulfat getrocknet, filtriert und das Lösungsmittel im Vakuum entfernt. Nach Säulenchromatographie über Kieselgel (Eluent: DCM/PE 20:80) wurde Verbindung A2 als farbloser Feststoff erhalten (97%).

Allgemeine Vorgehensweise A3: Eine Lösung von Dimethylformamid (1,30 eq) in 2 Vol. wasserfreiem DCM wurde bei 0°C mit Phosphoroxychlorid (1,20 eq) versetzt und 30 min bei 0°C gerührt. Diese Lösung wurde anschließend bei 0°C zu einer Lösung von Verbindung A2 (1 eq) in 8 Vol. wasserfreiem DCM zugetropft. Die Mischung wurde 2 h bei 20°C gerührt. Danach wurde die Mischung mit 25 Vol. NaOH-Lösung (1 M) versetzt und 40 min gerührt. Die organische Phase wurde abgetrennt und die wässrige Phase mit DCM extrahiert. Die organischen Phasen wurden mit Wasser und gesättigter NaCl-Lösung gewaschen. Anschließend wurde über Natriumsulfat getrocknet, filtriert und das Lösungsmittel im Vakuum entfernt. Nach Säulenchromatographie über Kieselgel (Eluent: DCM/EtOAc/PE 55:5:40) wurde Verbindung A3 als gelber Feststoff erhalten (86%).

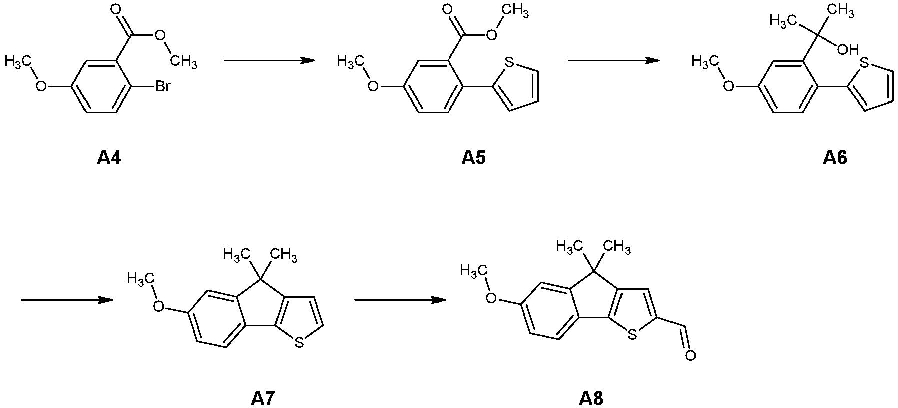

Allgemeine Vorgehensweise A5: Eine Lösung aus Methyl 2-Brom-5-methoxybenzoat A4 (1 eq) und 2-Thiophenboronsäure (1,10 eq) in 10 Vol. Isopropanol wurde mit einer Lösung von Kaliumphosphat (1,20 eq) in 2,5 Vol. Wasser versetzt und 20 min entgast. Anschließend wurde Bis-(tri-tert-butylphosphin)-palladium(0) (0,005 eq) zugegeben und 2 h bei 20°C gerührt. Die Mischung wurde auf Wasser gegeben und 3mal mit DCM extrahiert. Die organischen Phasen wurden mit Wasser und gesättigter NaCl-Lösung gewaschen. Dann wurde über Natriumsulfat getrocknet, filtriert und das Lösungsmittel im Vakuum entfernt. Nach Säulenchromatographie über Kieselgel (Eluent: EtOAc) wurde Verbindung A5 als rötliches Öl erhalten (97%).

Allgemeine Vorgehensweise A6: Eine Lösung von Verbindung A5 (1 eq) in 8 Vol. wasserfreiem THF wurde unter Rühren bei -10°C tropfenweise mit Methylmagnesiumbromid-Lösung (3,4 mol/L in THF) (3 eq) versetzt. Die Mischung wurde 3 h bei 40°C gerührt, auf -10°C gekühlt, und langsam mit HCl-Lösung (1 M, 2 eq) versetzt. Dann wurde gesättigte Ammoniumchlorid-Lösung zugegeben, bis ein pH-Wert von 7-8 erreicht wurde. Die Mischung wurde 3mal mit DCM extrahiert. Die organischen Phasen wurden über Natriumsulfat getrocknet, filtriert und das Lösungsmittel im Vakuum entfernt. Nach Säulenchromatographie über Kieselgel (Eluent: PE/EtOAc 83:17) wurde Verbindung A6 als gelbes Öl erhalten (87%).

Allgemeine Vorgehensweise A7: Eine Lösung von Verbindung A6 (1 eq) in 30 Vol. wasserfreiem DCM wurde bei -78°C tropfenweise mit Methansulfonsäure (2 eq) versetzt. Die Mischung wurde 30 min bei - 78°C gerührt, anschließend auf 0°C erwärmt und mit gesättigter Natriumhydrogencarbonat-Lösung versetzt. Dann wurde die die Mischung 3mal mit DCM extrahiert. Die organischen Phasen wurden mit Wasser gewaschen, über Natriumsulfat getrocknet, filtriert und das Lösungsmittel im Vakuum entfernt. Nach Säulenchromatographie über Kieselgel (Eluent: PE/DCM 67:33) wurde Verbindung A7 als farbloses Öl erhalten (65%).

Allgemeine Vorgehensweise A8: Eine Lösung von Dimethylformamid (1,50 eq) in 5 Vol. wasserfreiem DCM wurde bei 0°C mit Phosphoroxychlorid (1,50 eq) versetzt und 30 min bei 0°C gerührt. Diese Lösung wurde anschließend bei 0°C zu einer Lösung von Verbindung A7 (1 eq) in 3 Vol. wasserfreiem DCM zugetropft. Die Mischung wurde 1,5 h bei 20°C gerührt. Danach wurde die Mischung mit 25 Vol. NaOH-Lösung (1 M) versetzt und 2 h gerührt. Die organische Phase wurde abgetrennt und mit Wasser gewaschen. Anschließend wurde über Natriumsulfat getrocknet, filtriert und das Lösungsmittel im Vakuum entfernt. Nach Säulenchromatographie über Kieselgel (Eluent: DCM) wurde Verbindung A8 als gelber Feststoff erhalten (96%).

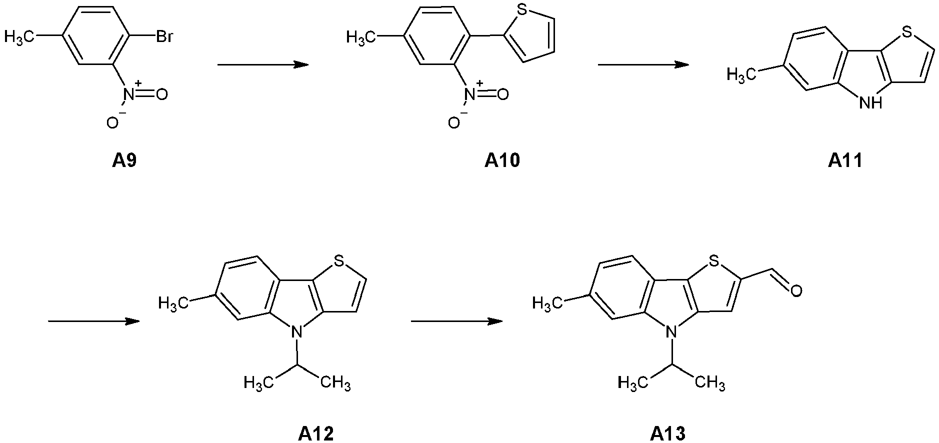

Allgemeine Vorgehensweise A10: Eine Lösung aus 4-Brom-3-nitrotoluol A9 (1 eq) und 2-Thiophenboronsäure (1,10 eq) in 18 Vol. Isopropanol wurde mit einer Lösung von Kaliumphosphat (1,20 eq) in 4,5 Vol. Wasser versetzt und 20 min entgast. Anschließend wurde Bis-(tri-tert-butylphosphin)-palladium(0) (0,01 eq) zugegeben und 2 h bei 20°C gerührt. Die Mischung wurde auf Wasser gegeben und 3mal mit DCM extrahiert. Die organischen Phasen wurden mit Wasser und gesättigter NaCl-Lösung gewaschen. Dann wurde über Natriumsulfat getrocknet, filtriert und das Lösungsmittel im Vakuum entfernt. Nach Säulenchromatographie über Kieselgel (Eluent: PE/DCM 67:33) wurde Verbindung A10 als farbloses Öl erhalten (99%).

Allgemeine Vorgehensweise A11: Eine Lösung von Verbindung 10 (1 eq) in Phosphorigsäuretriethylester (5 eq) wurde 16 h unter Rückfluss gerührt. Anschließend wurde die Mischung auf 20°C abgekühlt und das Lösungsmittel durch Vakuumdestillation entfernt. Nach Säulenchromatographie über Kieselgel (Eluent: PE/DCM 75:25) wurde Verbindung A11 als farbloser Feststoff erhalten (52%).

Allgemeine Vorgehensweise A12: Eine Lösung von Verbindung A11 (1 eq) und Kaliumhydroxid (2,10 eq) in 12 Vol. wasserfreiem DMSO wurde mit Isopropyliodid (2 eq) versetzt und 2 Tage bei 20°C gerührt. Anschließend wurde die Mischung auf Wasser gegeben und 3mal mit EtOAc extrahiert. Die organischen Phasen wurden über Natriumsulfat getrocknet, filtriert und das Lösungsmittel im Vakuum entfernt. Nach Säulenchromatographie über Kieselgel (Eluent: PE/DCM 67:33) wurde Verbindung A12 als farbloser Feststoff erhalten (92%).

Allgemeine Vorgehensweise A13: Eine Lösung von Dimethylformamid (1,50 eq) in 4 Vol. wasserfreiem DCM wurde bei 0°C mit Phosphoroxychlorid (1,60 eq) versetzt und 40 min bei 0°C gerührt. Diese Lösung wurde anschließend bei 0°C zu einer Lösung von Verbindung A12 (1 eq) in 4 Vol. wasserfreiem DCM zugetropft. Die Mischung wurde 2,5 h bei 20°C gerührt. Danach wurde die Mischung mit 25 Vol. NaOH-Lösung (1 M) versetzt und 2 h gerührt. Die organische Phase wurde abgetrennt und mit Wasser gewaschen. Anschließend wurde über Natriumsulfat getrocknet, filtriert und das Lösungsmittel im Vakuum entfernt. Nach Säulenchromatographie über Kieselgel (Eluent: EtOAc) wurde Verbindung A13 als gelber Feststoff erhalten (96%). 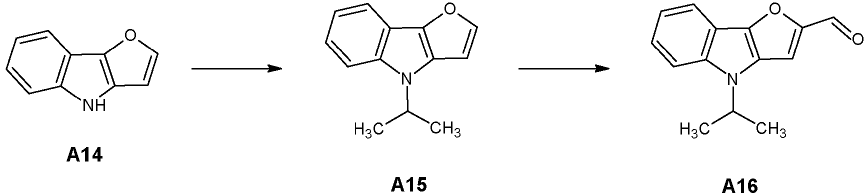 Allgemeine Vorgehensweise A14: WO2022126179A1

Allgemeine Vorgehensweise A15: Eine Lösung von Verbindung A14 (1 eq) und Kaliumhydroxid (2,60 eq) in 12 Vol. wasserfreiem DMSO wurde mit Isopropyliodid (2,50 eq) versetzt und 3 h bei 20°C gerührt. Anschließend wurde die Mischung auf Wasser gegeben und 3mal mit EtOAc extrahiert. Die organischen Phasen wurden über Natriumsulfat getrocknet, filtriert und das Lösungsmittel im Vakuum entfernt. Nach Säulenchromatographie über Kieselgel (Eluent: PE/DCM 67:33) wurde Verbindung A15 als farbloser Feststoff erhalten (86%).

Allgemeine Vorgehensweise A16: Eine Lösung von Dimethylformamid (1,60 eq) in 4 Vol. wasserfreiem DCM wurde bei 0°C mit Phosphoroxychlorid (1,50 eq) versetzt und 40 min bei 0°C gerührt. Diese Lösung wurde anschließend bei 0°C zu einer Lösung von Verbindung A15 (1 eq) in 4 Vol. wasserfreiem DCM zugetropft. Die Mischung wurde 1,5 h bei 20°C gerührt. Danach wurde die Mischung mit 30 Vol. NaOH-Lösung (1 M) versetzt und 2 h gerührt. Die organische Phase wurde abgetrennt und mit Wasser gewaschen. Anschließend wurde über Natriumsulfat getrocknet, filtriert und das Lösungsmittel im Vakuum entfernt. Nach Säulenchromatographie über Kieselgel (Eluent: PE/DCM 50:50) wurde Verbindung A16 als orangefarbener Feststoff erhalten (90%). 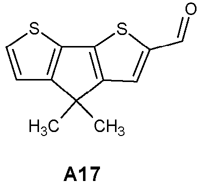
Allgemeine Vorgehensweise A17: Yan et al. (J.Org.Chem., 2008, 73, 17, 6587-6594) 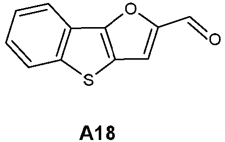
Allgemeine Vorgehensweise A18: Svoboda et al. (Collect.Czech.Chem. Commun., 1996, 61, 888-900)

## Patentansprüche

1. Chemische Verbindung der allgemeinen Formel Ia oder Ib 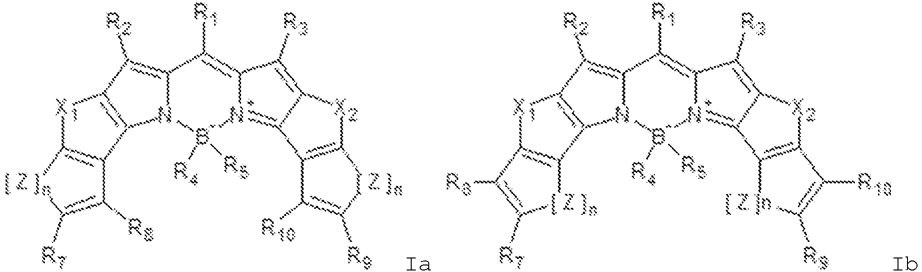 **dadurch gekennzeichnet, dass**
X₁ und X₂ unabhängig voneinander O, S, oder NR₆ sind, mit R₆ ausgewählt aus der Gruppe bestehend aus H, Alkyl, Alkoxy, Amino, Aryl, und Heteroaryl,
R₁ ausgewählt ist aus der Gruppe bestehend aus F, fluoriertem oder teilfluoriertem Alkyl, und einem aromatischen heterocyclischen 5-Ring oder 6-Ring oder einem aromatischen homocyclischen 6-Ring,
R₂ und R₃ jeweils unabhängig voneinander ausgewählt sind aus der Gruppe bestehend aus H, Halogen, CN, Alkyl, Alkoxy, Amino, Aryl und Heteroaryl,
R₄ und R₅ jeweils unabhängig voneinander ausgewählt sind aus der Gruppe bestehend aus Halogen, bevorzugt F, und fluoriertem oder teilfluoriertem Alkyl,
mit Z unabhängig voneinander ausgewählt aus der Gruppe bestehend aus O, S, CH₂, CHR₁₁, CR₁₂R₁₃, SiHR₁₁, SiR₁₂R₁₃, NH, NR₁₄, PR₁₅, mit R₁₁, R₁₂, R₁₃, R₁₄ und R₁₅ unabhängig voneinander ausgewählt aus der Gruppe bestehend aus Halogen, Alkyl, Alkoxy, Amino, Aryl, und Heteroaryl, mit n unabhängig voneinander 1 oder 2,
wobei R₇ und R₈ und/oder R₉ und R₁₀ jeweils zusammen einen heterocyclischen 5-Ring oder 6-Ring mit mindestens einem Heteroatom ausgewählt aus der Gruppe bestehend aus O, S, N, Si oder P, oder einen homocyclischen 6-Ring bilden, wobei der heterocyclische 5-Ring oder 6-Ring oder der homocyclische 6-Ring jeweils weiter anelliert sein kann.

2. Chemische Verbindung nach Anspruch 1, wobei R₁ ausgewählt ist aus der Gruppe bestehend aus F, CF₃, C₂F₅, und einem aromatischen heterocyclischen 5-Ring oder 6-Ring oder einem aromatischen homocyclischen 6-Ring, wobei bevorzugt mindestens ein H-Atom durch F, Cl und/oder CF₃ substituiert ist, bevorzugt einem aromatischen heterocyclischen 6-Ring oder einem aromatischen homocyclischen 6-Ring, wobei mindestens zwei H-Atome, durch F, Cl und/oder CF₃ substituiert sind.

3. Chemische Verbindung nach Anspruch 1 oder 2, wobei R₇ und R₈ und/oder R₉ und R₁₀ jeweils zusammen einen aromatischen homocyclischen 6-Ring bilden, wobei bevorzugt mindestens ein H-Atom des homocyclischen 6-Rings durch Halogen, Alkyl, Alkoxy, Aryl oder Heteroaryl substituiert ist, und/oder der homocyclische 6-Ring nicht weiter anelliert ist.

4. Chemische Verbindung nach einem der vorhergehenden Ansprüche, wobei R₇ und R₈ und/oder R₉ und R₁₀ jeweils zusammen einen aromatischen heterocyclischen 5-Ring oder 6-Ring mit mindestens einem Heteroatom ausgewählt aus der Gruppe bestehend aus O, S, N, Si oder P bilden, wobei bevorzugt mindestens ein H-Atom des heterocyclischen 5-Rings oder 6-Rings durch Halogen, Alkyl, Alkoxy, Aryl oder Heteroaryl substituiert ist, und/oder der heterocyclische 5-Ring oder 6-Ring nicht weiter anelliert ist.

5. Chemische Verbindung nach einem der vorhergehenden Ansprüche, wobei R₂ gleich R₃ ist, R₄ gleich R₅ ist, und/oder R₇ und R₈ gleich R₉ und R₁₀ sind.

6. Chemische Verbindung nach einem der vorhergehenden Ansprüche, wobei die chemische Verbindung die allgemeine Formel IIa, IIb, IIc und/oder IId aufweist 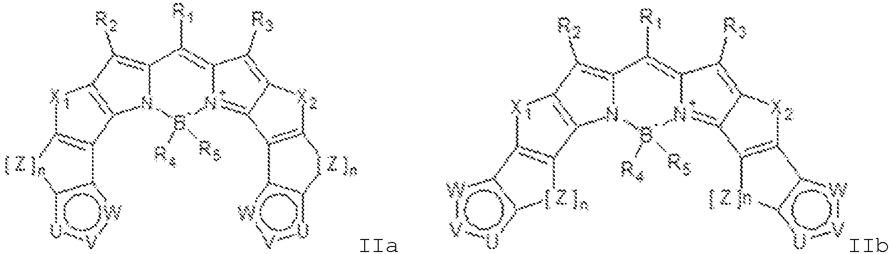 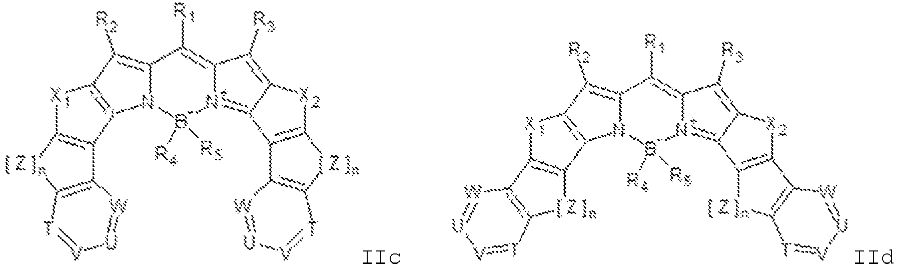
mit U, V und W der Formel IIa und IIb unabhängig voneinander ausgewählt aus der Gruppe bestehend aus CR₁₆, O, S, N, NR₁₇ mit R₁₆ und R₁₇ unabhängig voneinander ausgewählt aus der Gruppe bestehend aus H, Halogen, Alkyl, Alkoxy, Alkylthiooxy, Amino, Aryl, und Heteroaryl,
mit T, U, V und W der Formel IIc und IId unabhängig voneinander ausgewählt aus der Gruppe bestehend aus CH, CR₁₈ und N mit R₁₈ unabhängig voneinander ausgewählt aus der Gruppe bestehend aus Halogen, Alkyl, Alkoxy, Alkylthiooxy, Amino, Aryl, und Heteroaryl,
wobei an U, V und W der Formel IIa und IIb oder an T, U, V und W der Formel IIc und IId ein heterocyclischer 5-Ring oder 6-Ring mit mindestens einem Heteroatom ausgewählt aus der Gruppe bestehend aus O, S, und N oder ein homocyclischer 6-Ring anelliert sein kann,
mit Z unabhängig voneinander ausgewählt aus der Gruppe bestehend aus O, S, CH₂, CHR₁₁, CR₁₂R₁₃, SiHR₁₁, SiR₁₂R₁₃, NH, NR₁₄, PR₁₅, mit R₁₁, R₁₂, R₁₃, R₁₄ und R₁₅ unabhängig voneinander ausgewählt aus der Gruppe bestehend aus Alkyl, Alkoxy, Amino, Aryl, und Heteroaryl, und mit n unabhängig voneinander 1 oder 2.

7. Chemische Verbindung nach einem der vorhergehenden Ansprüche, wobei mindestens ein U, V, und W der Formel IIa und IIb ein O oder S ist, bevorzugt U oder W,
wobei T, U, V und W der Formel IIc und IId unabhängig voneinander ausgewählt sind aus der Gruppe bestehend aus CH und CR₁₈ mit R₁₈ unabhängig voneinander ausgewählt aus der Gruppe bestehend aus Alkyl, Alkoxy, Aryl, und Heteroaryl, und/oder
wobei mindestens U oder V der Formel IIc und IId CR₁₈ ist mit R₁₈ ausgewählt aus der Gruppe bestehend aus Alkyl, Alkoxy, Aryl, und Heteroaryl, oder T, U, V und W der Formel IIc und IId unabhängig voneinander CH oder CR₁₈ sind mit R₁₈ Alkyl, bevorzugt sind T, U, V und W der Formel IIc und IId H.

8. Chemische Verbindung nach einem der vorhergehenden Ansprüche, wobei Z unabhängig voneinander ausgewählt ist aus der Gruppe bestehend aus O, S, CH₂, CHR₁₁, CR₁₂R₁₃, SiHR₁₁, SiR₁₂R₁₃, NR₁₄, PR₁₅, mit R₁₁, R₁₂, R₁₃, R₁₄ und R₁₅ unabhängig voneinander ausgewählt aus der Gruppe bestehend aus Alkyl, Alkoxy, bevorzugt Alkyl, oder Z unabhängig voneinander ausgewählt ist aus der Gruppe bestehend aus O, S, CH₂, CHR₁₁ oder CR₁₂R₁₃, mit R₁₁, R₁₂ und R₁₃ unabhängig voneinander ausgewählt aus der Gruppe bestehend aus Alkyl, Aryl und Heteroaryl, und/oder wobei n 1 ist.

9. Chemische Verbindung nach einem der vorhergehenden Ansprüche, wobei R₄ und R₅ F sind, und/oder wobei X₁ und X₂ jeweils O oder S sind.

10. Chemische Verbindung nach einem der vorhergehenden Ansprüche, wobei R₂ und R₃ jeweils unabhängig voneinander ausgewählt sind aus der Gruppe bestehend aus H, Alkyl, Alkoxy, Aryl und Heteroaryl, bevorzugt sind R₂ und R₃ H oder Alkyl, insbesondere bevorzugt H, Methyl, Ethyl, oder Propyl.

11. Chemische Verbindung nach einem der vorhergehenden Ansprüche, wobei Z ausgewählt ist aus CH₂, CHR₁₁, und CR₁₂R₁₃ mit R₁₁, R₁₂ und R₁₃ unabhängig voneinander ausgewählt aus der Gruppe bestehend aus Alkyl, Alkoxy, Aryl und Heteroaryl, bevorzugt H oder Alkyl, und/oder wobei n 1 ist.

12. Chemische Verbindung nach einem der vorhergehenden Ansprüche, wobei die chemische Verbindung ausgewählt ist aus der Gruppe bestehend aus

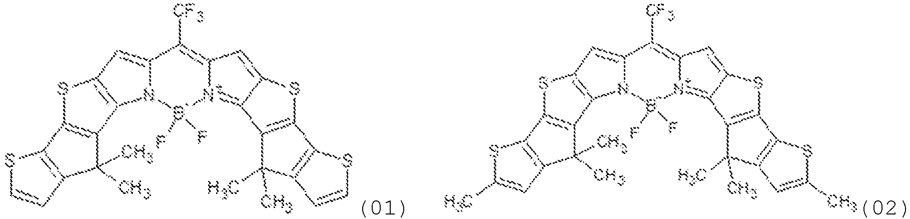

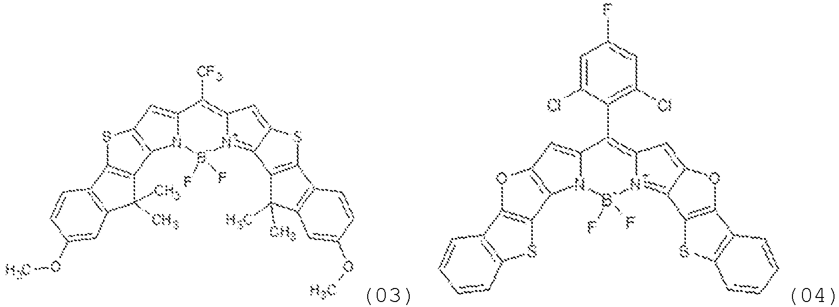

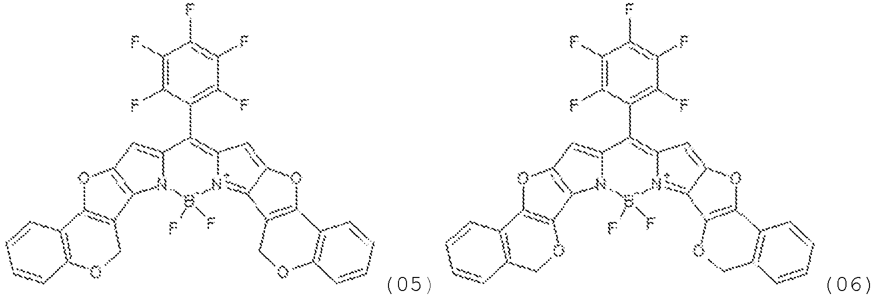

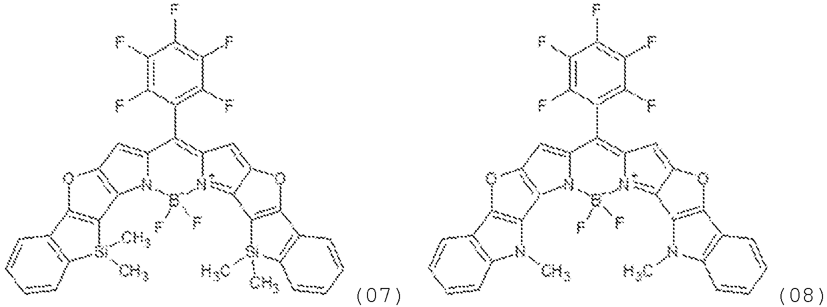

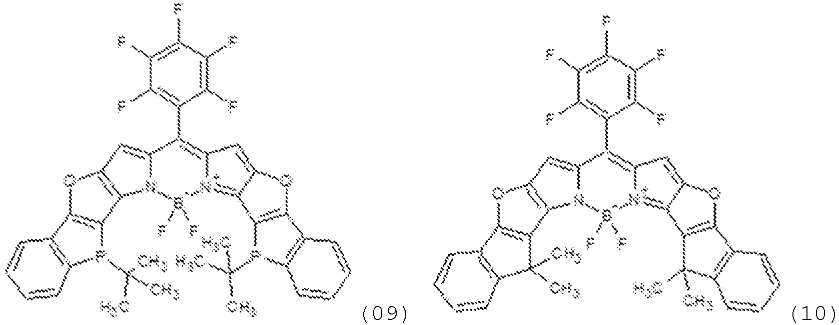

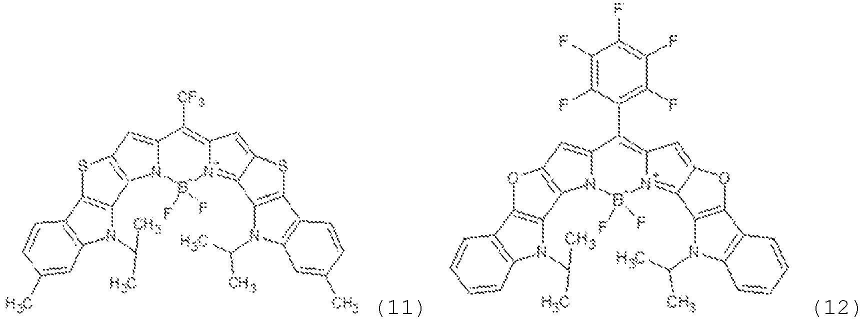

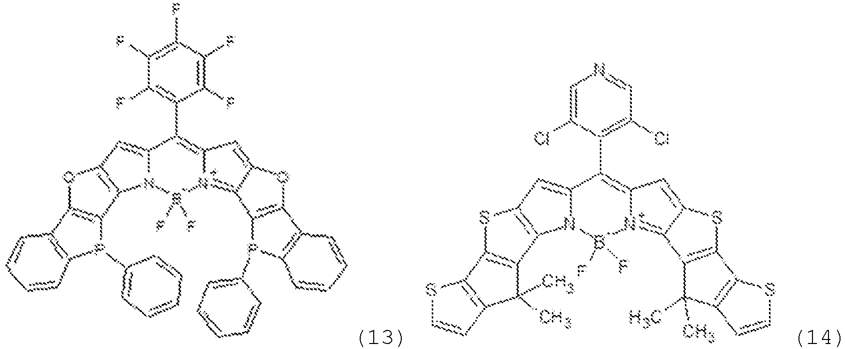

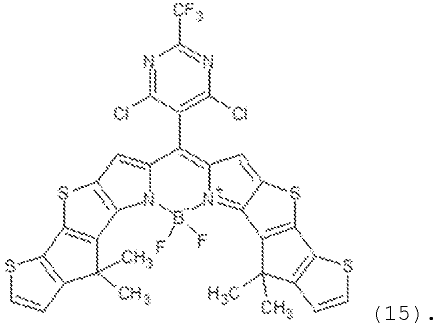

13. Optoelektronisches Bauelement (10) umfassend eine erste Elektrode (2), eine zweite Elektrode (6) und ein Schichtsystem (7), wobei das Schichtsystem (7) zwischen der ersten Elektrode (2) und der zweiten Elektrode (6) angeordnet ist, **dadurch gekennzeichnet, dass** mindestens eine Schicht des Schichtsystems (7) mindestens eine chemische Verbindung nach einem der Ansprüche 1 bis 12 aufweist.

14. Optoelektronisches Bauelement (10) nach Anspruch 13, wobei das optoelektronische Bauelement ein Schichtsystem (7) mit mindestens einer photoaktiven Schicht (4) aufweist, bevorzugt eine lichtabsorbierende photoaktive Schicht (4), wobei die mindestens eine photoaktive Schicht (4) die mindestens eine chemische Verbindung aufweist, wobei das optoelektronische Bauelement (10) bevorzugt ein organisches photovoltaisches Element, ein OFET (organischer Feldeffekttransistor), eine OLED (organic light emitting diode), oder ein organischer Photodetektor ist.

15. Verwendung einer chemischen Verbindung nach einem der Ansprüche 1 bis 12 in einem optoelektronischen Bauelement (10), bevorzugt in einem organischen photovoltaischen Element, einem OFET (organischer Feldeffekttransistor), einer OLED (organic light emitting diode), oder einem organischen Photodetektor.

## Claims

1. Chemical compound of general formula Ia or Ib 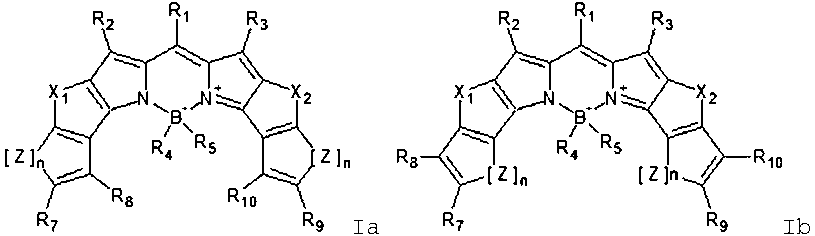 **characterized in that**
X₁ and X₂ are each independently O, S or NR₆, wherein R₆ is selected from the group consisting of H, alkyl, alkoxy, amino, aryl, and heteroaryl,
R₁ is selected from the group consisting of F, fluorinated or partially fluorinated alkyl, and an aromatic heterocyclic 5-membered ring or 6-membered ring or an aromatic homocyclic 6-membered ring,
R₂ and R₃ are each independently selected from the group consisting of H, halogen, CN, alkyl, alkoxy, amino, aryl, and heteroaryl,
R₄ and R₅ are each independently selected from the group consisting of halogen, preferably F, and fluorinated or partially fluorinated alkyl,
wherein Z is in each case independently selected from the group consisting of O, S, CH₂, CHR₁₁, CR₁₂R₁₃, SiHR₁₁, SiR₁₂R₁₃, NH, NR₁₄, PR₁₅, where R₁₁, R₁₂, R₁₃, R₁₄, and R₁₅ are each independently selected from the group consisting of halogen, alkyl, alkoxy, amino, aryl, and heteroaryl, wherein n is in each case independently 1 or 2,
wherein R₇ and R₈ and/or R₉ and R₁₀ in each case together form a heterocyclic 5-membered ring or 6-membered ring containing at least one heteroatom selected from the group consisting of O, S, N, Si or P, or form a homocyclic 6-membered ring, it being possible for the heterocyclic 5-membered ring or 6-membered ring or homocyclic 6-membered ring to be fused to further rings in each case.

2. Chemical compound according to Claim 1, wherein R₁ is selected from the group consisting of F, CF₃, C₂F₅, and an aromatic heterocyclic 5-membered ring or 6-membered ring or an aromatic homocyclic 6-membered ring, wherein preferably at least one hydrogen atom is substituted by F, Cl and/or CF₃, preferably an aromatic heterocyclic 6-membered ring or an aromatic homocyclic 6-membered ring, wherein at least two hydrogen atoms are substituted by F, Cl and/or CF₃.

3. Chemical compound according to Claim 1 or 2, wherein R₇ and R₈ and/or R₉ and R₁₀ in each case together form an aromatic homocyclic 6-membered ring, wherein preferably at least one hydrogen atom of the homocyclic 6-membered ring is substituted by halogen, alkyl, alkoxy, aryl or heteroaryl and/or the homocyclic 6-membered ring is not further fused.

4. Chemical compound according to any of the preceding claims, wherein R₇ and R₈ and/or R₉ and R₁₀ in each case together form an aromatic heterocyclic 5-membered ring or 6-membered ring with at least one heteroatom selected from the group consisting of O, S, N, Si or P, wherein preferably at least one hydrogen atom of the heterocyclic 5-membered ring or 6-membered ring is substituted by halogen, alkyl, alkoxy, aryl or heteroaryl and/or the heterocyclic 5-membered ring or 6-membered ring is not further fused.

5. Chemical compound according to any of the preceding claims, wherein R₂ is the same as R₃, R₄ is the same as R₅, and/or R₇ and R₈ are the same as R₉ and R₁₀.

6. Chemical compound according to any of the preceding claims, wherein the chemical compound has the general formula IIa, IIb, IIc and/or IId: 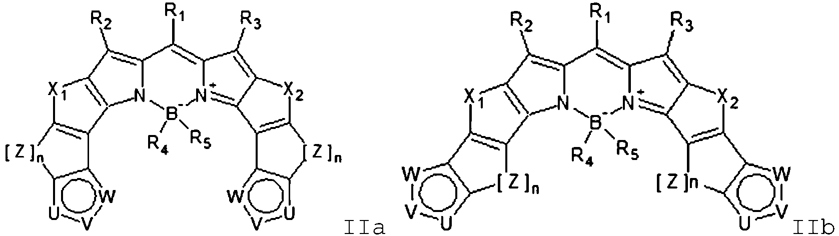 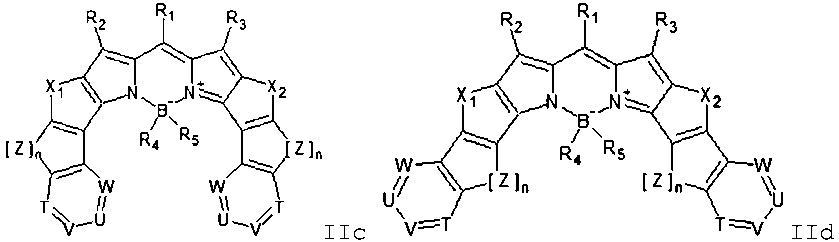
wherein U, V, and W in formula IIa and IIb are each independently selected from the group consisting of CR₁₆, O, S, N, NR₁₇, wherein R₁₆ and R₁₇ are each independently selected from the group consisting of H, halogen, alkyl, alkoxy, alkylthiooxy, amino, aryl, and heteroaryl,
wherein T, U, V, and W in formula IIc and IId are each independently selected from the group consisting of CH, CR₁₈, and N, wherein R₁₈ is in each case independently selected from the group consisting of halogen, alkyl, alkoxy, alkylthiooxy, amino, aryl, and heteroaryl,
wherein U, V, and W in formula IIa and IIb or T, U, V, and W in formula IIc and IId may be fused to a heterocyclic 5-membered ring or 6-membered ring with at least one heteroatom selected from the group consisting of O, S, and N or a homocyclic 6-membered ring,
wherein Z is in each case independently selected from the group consisting of O, S, CH₂, CHR₁₁, CR₁₂R₁₃, SiHR₁₁, SiR₁₂R₁₃, NH, NR₁₄, PR₁₅, wherein R₁₁, R₁₂, R₁₃, R₁₄, and R₁₅ are each independently selected from the group consisting of alkyl, alkoxy, amino, aryl, and heteroaryl, and wherein n is in each case independently 1 or 2.

7. Chemical compound according to any of the preceding claims, wherein at least one U, V, and W in formula IIa and IIb is O or S, preferably U or W,
wherein T, U, V, and W in formula IIc and IId are each independently selected from the group consisting of CH and CR₁₈, wherein R₁₈ is in each case independently selected from the group consisting of alkyl, alkoxy, aryl, and heteroaryl, and/or
wherein at least U or V in formula IIc and IId is CR₁₈, wherein R₁₈ is selected from the group consisting of alkyl, alkoxy, aryl, and heteroaryl, or T, U, V, and W in formula IIc and IId are each independently CH or CR₁₈, wherein R₁₈ is alkyl, preferably T, U, V, and W in formula IIc and IId are H.

8. Chemical compound according to any of the preceding claims, wherein Z is in each case independently selected from the group consisting of O, S, CH₂, CHR₁₁, CR₁₂R₁₃, SiHR₁₁, SiR₁₂R₁₃, NR₁₄, PR₁₅, wherein R₁₁, R₁₂, R₁₃, R₁₄, and R₁₅ are each independently selected from the group consisting of alkyl, alkoxy, preferably alkyl, or Z is in each case independently selected from the group consisting of O, S, CH₂, CHR₁₁, and CR₁₂R₁₃, wherein R₁₁, R₁₂, and R₁₃ are each independently selected from the group consisting of alkyl, aryl, and heteroaryl, and/or wherein n is 1.

9. Chemical compound according to any of the preceding claims, wherein R₄ and R₅ are F, and/or X₁ and X₂ are each O or S.

10. Chemical compound according to any of the preceding claims, wherein R₂ and R₃ are each independently selected from the group consisting of H, alkyl, alkoxy, aryl, and heteroaryl, wherein preferably R₂ and R₃ are H or alkyl, particularly preferably H, methyl, ethyl, or propyl.

11. Chemical compound according to any of the preceding claims, wherein Z is selected from CH₂, CHR₁₁, and CR₁₂R₁₃, wherein R₁₁, R₁₂, and R₁₃ are each independently selected from the group consisting of alkyl, alkoxy, aryl and heteroaryl, preferably H or alkyl, and/or wherein n is 1.

12. Chemical compound according to any of the preceding claims, wherein the chemical compound is selected from the group consisting of:

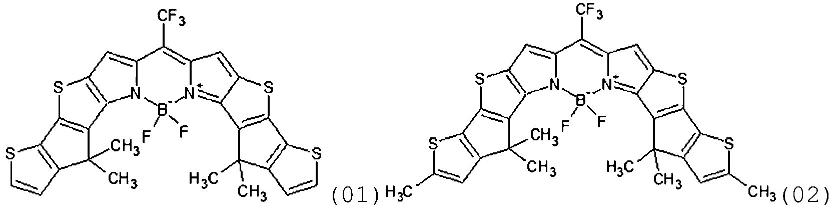

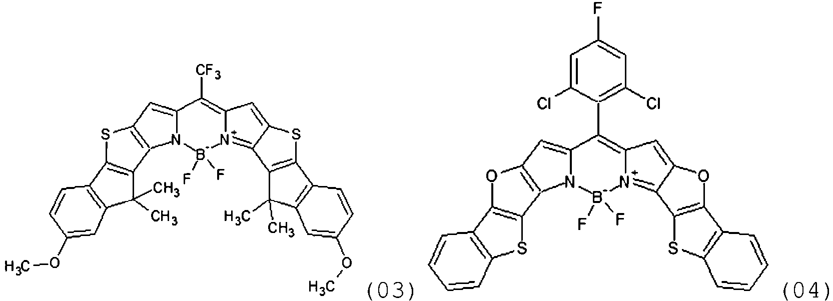

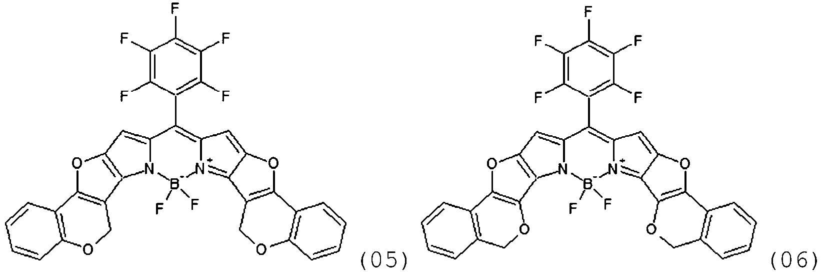

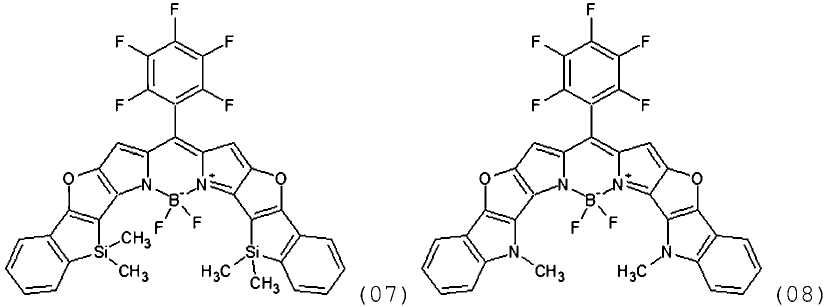

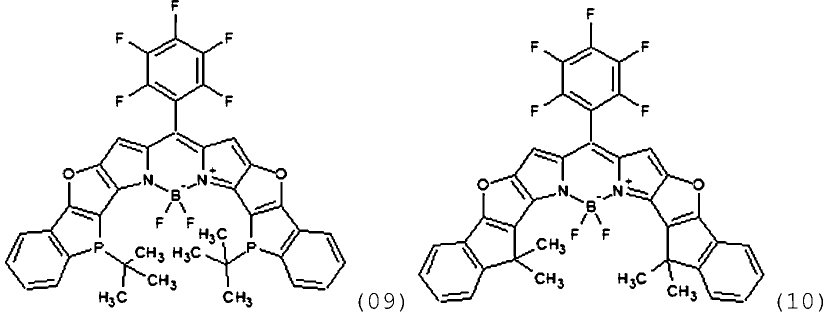

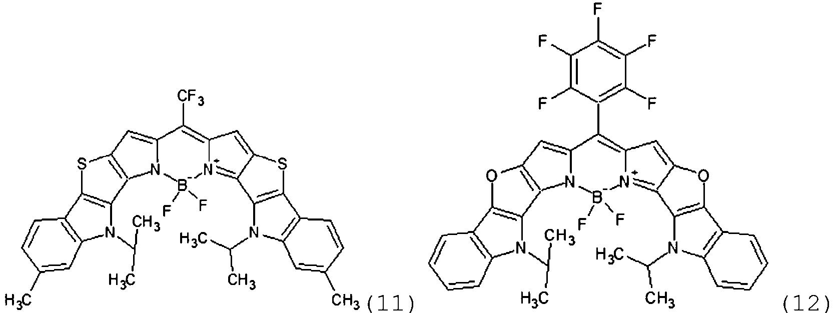

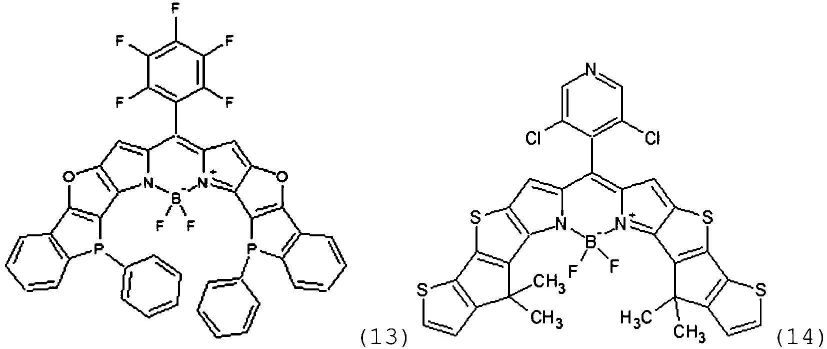

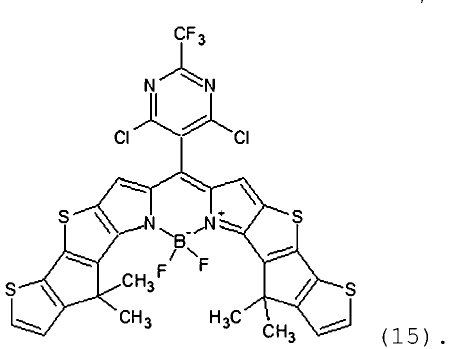

13. Optoelectronic component (10) comprising a first electrode (2), a second electrode (6), and a layer system (7), the layer system (7) being arranged between the first electrode (2) and the second electrode (6), **characterized in that** at least one layer of the layer system (7) comprises at least one chemical compound according to any of Claims 1 to 12.

14. Optoelectronic component (10) according to Claim 13, wherein the optoelectronic component comprises a layer system (7) having at least one photoactive layer (4), preferably a light-absorbing photoactive layer (4), wherein the at least one photoactive layer (4) comprises the at least one chemical compound, wherein the optoelectronic component (10) is preferably an organic photovoltaic element, an OFET (organic field-effect transistor), an OLED (organic light-emitting diode), or an organic photodetector.

15. Use of a chemical compound according to any of Claims 1 to 12 in an optoelectronic component (10), preferably in an organic photovoltaic element, an OFET (organic field-effect transistor), an OLED (organic light-emitting diode), or an organic photodetector.

## Revendications

1. Composé chimique de formule générale Ia ou Ib 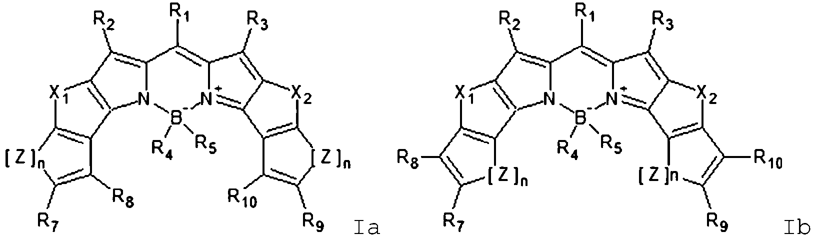 **caractérisé en ce que**
X₁ et X₂ sont, indépendamment l'un de l'autre, O, S ou NR₆, R₆ étant sélectionné dans le groupe constitué par H, alkyle, alcoxy, amino, aryle et hétéroaryle,
R₁ est sélectionné dans le groupe constitué par F, un alkyle fluoré ou partiellement fluoré, et un hétérocycle aromatique à 5 chaînons ou à 6 chaînons ou un homocycle aromatique à 6 chaînons,
R₂ et R₃ sont chacun, indépendamment l'un de l'autre, sélectionnés dans le groupe constitué par H, halogène, CN, alkyle, alcoxy, amino, aryle et hétéroaryle,
R₄ et R₅ sont chacun, indépendamment l'un de l'autre, sélectionnés dans le groupe constitué par un halogène, de préférence F, et un alkyle fluoré ou partiellement fluoré,
les Z étant, indépendamment les uns des autres, sélectionnés dans le groupe constitué par O, S, CH₂, CHR₁₁, CR₁₂R₁₃, SiHR₁₁, SiR₁₂R₁₃, NH, NR₁₄, PR₁₅, où R₁₁, R₁₂, R₁₃, R₁₄ et R₁₅ sont, indépendamment les uns des autre, sélectionnés dans le groupe constitué par halogène, alkyle, alcoxy, amino, aryle et hétéroaryle, les n étant, indépendamment les uns des autres, 1 ou 2,
R₇ et R₈ et/ou R₉ et R₁₀ formant conjointement, respectivement, un hétérocycle à 5 chaînons ou à 6 chaînons comportant au moins un hétéroatome sélectionné dans le groupe constitué par O, S, N, Si ou P, ou un homocycle à 6 chaînons, l'hétérocycle à 5 chaînons ou à 6 chaînons ou l'homocycle à 6 chaînons pouvant chacun être en outre anellé.

2. Composé chimique selon la revendication 1, dans lequel R₁ est sélectionné dans le groupe constitué par F, CF₃, C₂F₅, et un hétérocycle aromatique à 5 chaînons ou à 6 chaînons ou un homocycle aromatique à 6 chaînons, dans lequel, de préférence, au moins un atome H est substitué par F, Cl et/ou CF₃, de préférence un hétérocycle aromatique à 6 chaînons ou un homocycle aromatique à 6 chaînons, dans lequel au moins deux atomes H sont substitués par F, Cl et/ou CF₃.

3. Composé chimique selon la revendication 1 ou 2, dans lequel R₇ et R₈ et/ou R₉ et R₁₀ forment conjointement, respectivement, un homocycle aromatique à 6 chaînons, dans lequel, de préférence, au moins un atome H de l'homocycle à 6 chaînons est substitué par halogène, alkyle, alcoxy, aryle ou hétéroaryle, et/ou l'homocycle à 6 chaînons n'est pas davantage anellé.

4. Composé chimique selon l'une quelconque des revendications précédentes, dans lequel R₇ et R₈ et/ou R₉ et R₁₀ forment conjointement, respectivement, un hétérocycle aromatique à 5 chaînons ou à 6 chaînons comportant au moins un hétéroatome sélectionné dans le groupe constitué par O, S, N, Si ou P, dans lequel, de préférence, au moins un atome H de l'hétérocycle à 5 chaînons ou à 6 chaînons est remplacé par halogène, alkyle, alcoxy, aryle ou hétéroaryle, et/ou l'hétérocycle à 5 chaînons ou à 6 chaînons n'est pas davantage anellé.

5. Composé chimique selon l'une quelconque des revendications précédentes, dans lequel R₂ est identique à R₃, R₄ est identique à R₅ et/ou R₇ et R₈ sont identiques à R₉ et R₁₀.

6. Composé chimique selon l'une quelconque des revendications précédentes, dans lequel le composé chimique présente la formule générale IIa, IIb, IIc et/ou IId 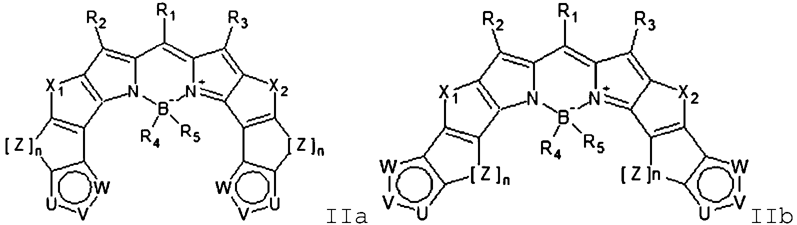 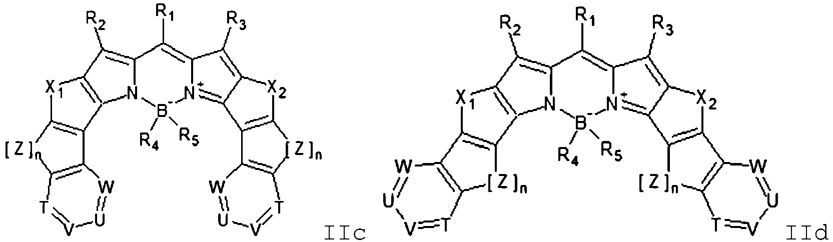
U, V et W de la formule IIa et IIb étant, indépendamment les uns des autres, sélectionnés dans le groupe constitué par CR₁₆, O, S, N, NR₁₇, où R₁₆ et R₁₇ sont, indépendamment l'un de l'autre, sélectionnés dans le groupe constitué par H, halogène, alkyle, alcoxy, alkylthiooxy, amino, aryle et hétéroaryle,
T, U, V et W de la formule IIc et IId étant, indépendamment les uns des autres, sélectionnés dans le groupe constitué par CH, CR₁₈ et N, où les R₁₈ sont, indépendamment les uns des autres, sélectionnés dans le groupe constitué par halogène, alkyle, alcoxy, alkylthiooxy, amino, aryle et hétéroaryle, un hétérocycle à 5 chaînons ou à 6 chaînons comportant au moins un hétéroatome sélectionné dans le groupe constitué par O, S et N ou un homocycle à 6 chaînons pouvant être anellé à U, V et W de la formule IIa et IIb ou à T, U, V et W de la formule IIc et IId,
les Z étant, indépendamment les uns des autres, sélectionnés dans le groupe constitué par O, S, CH₂, CHR₁₁, CR₁₂R₁₃, SiHR₁₁, SiR₁₂R₁₃, NH, NR₁₄, PR₁₅, où R₁₁, R₁₂,
R₁₃, R₁₄ et R₁₅ sont, indépendamment les uns des autres, sélectionnés dans le groupe constitué par alkyle, alcoxy, amino, aryle et hétéroaryle, et les n sont, indépendamment les uns des autres, 1 ou 2.

7. Composé chimique selon l'une quelconque des revendications précédentes, dans lequel au moins un de U, V et W de la formule IIa et IIb est O ou S, de préférence U ou W,
dans lequel T, U, V et W de la formule IIc et IId sont, indépendamment les uns des autres, sélectionnés dans le groupe constitué par CH et CR₁₈, les R₁₈ étant, indépendamment les uns des autres, sélectionnés dans le groupe constitué par alkyle, alcoxy, aryle et hétéroaryle, et/ou
dans lequel au moins U ou V de la formule IIc et IId est CR₁₈, R₁₈ étant sélectionné dans le groupe constitué par alkyle, alcoxy, aryle et hétéroaryle, ou T, U, V et W de la formule IIc et IId sont, indépendamment les uns des autres, CH ou CR₁₈, R₁₈ étant alkyle, de préférence T, U, V et W de la formule IIc et IId sont H.

8. Composé chimique selon l'une quelconque des revendications précédentes, dans lequel les Z sont, indépendamment les uns des autres, sélectionnés dans le groupe constitué par O, S, CH₂, CHR₁₁, CR₁₂R₁₃, SiHR₁₁, SiR₁₂R₁₃, NR₁₄, PR₁₅, où R₁₁, R₁₂, R₁₃, R₁₄ et R₁₅ sont, indépendamment les uns des autres, sélectionnés dans le groupe constitué par alkyle, alcoxy, de préférence alkyle, ou les Z sont, indépendamment les uns des autres, sélectionnés dans le groupe constitué par O, S, CH₂, CHR₁₁ ou CR₁₂R₁₃, où R₁₁, R₁₂ et R₁₃ sont, indépendamment les uns des autres, sélectionnés dans le groupe constitué par alkyle, aryle et hétéroaryle, et/ou n est 1.

9. Composé chimique selon l'une quelconque des revendications précédentes, dans lequel R₄ et R₅ sont F, et/ou dans lequel X₁ et X₂ sont chacun O ou S.

10. Composé chimique selon l'une quelconque des revendications précédentes, dans lequel R₂ et R₃ sont chacun, indépendamment l'un de l'autre, sélectionnés dans le groupe constitué par H, alkyle, alcoxy, aryle et hétéroaryle, de préférence R₂ et R₃ sont H ou alkyle, de manière particulièrement préférée H, méthyle, éthyle ou propyle.

11. Composé chimique selon l'une quelconque des revendications précédentes, dans lequel Z est sélectionné dans le groupe constitué par CH₂, CHR₁₁ et CR₁₂R₁₃, où R₁₁, R₁₂ et R₁₃ sont, indépendamment les uns des autres, sélectionnés dans le groupe constitué par alkyle, alcoxy, aryle et hétéroaryle, de préférence H ou alkyle, et/ou n est 1.

12. Composé chimique selon l'une quelconque des revendications précédentes, dans lequel le composé chimique est sélectionné dans le groupe constitué par

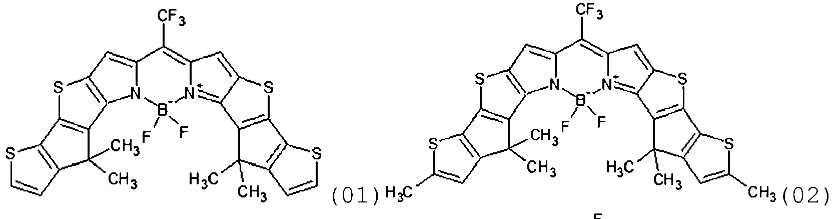

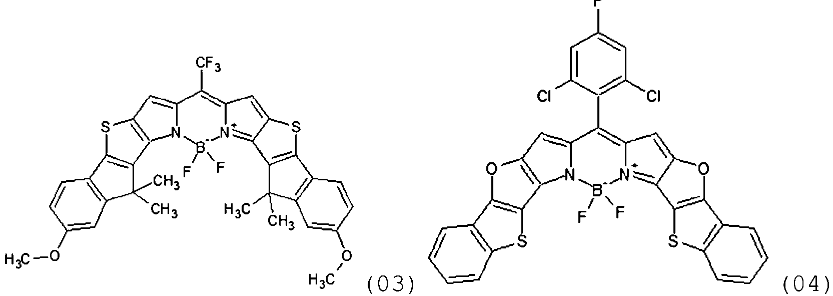

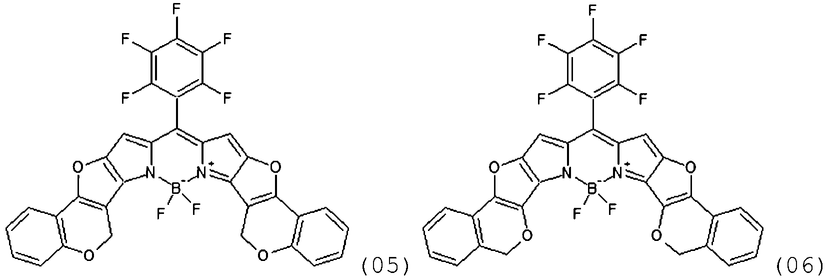

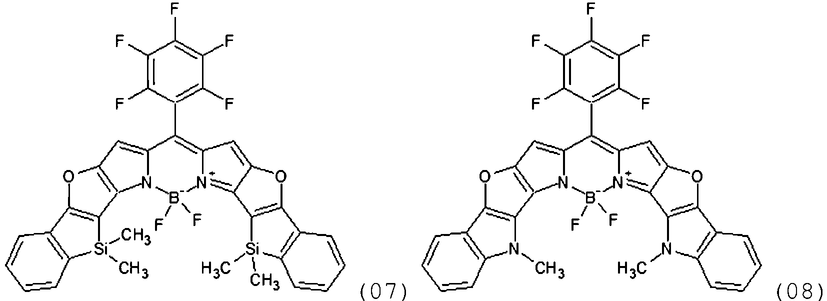

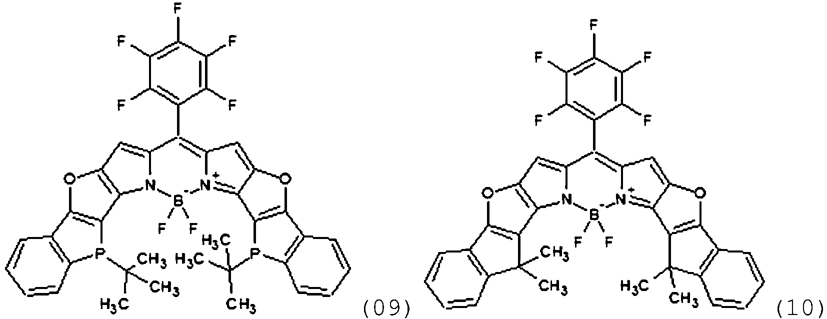

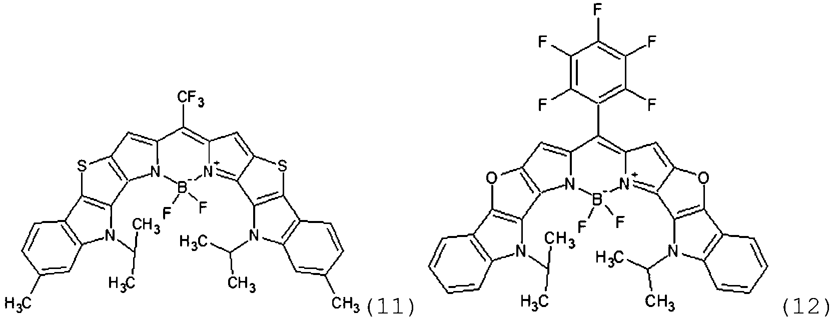

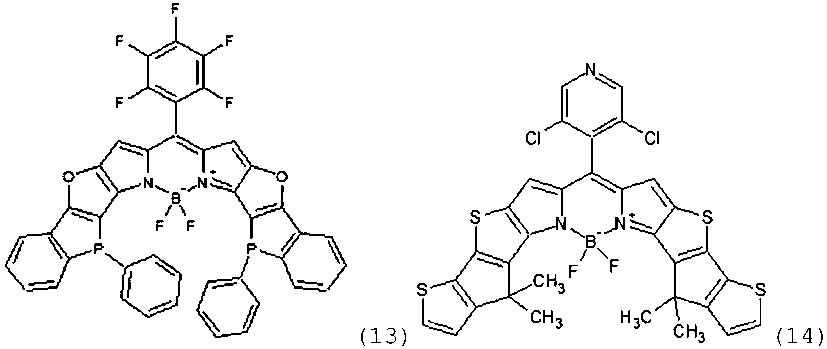

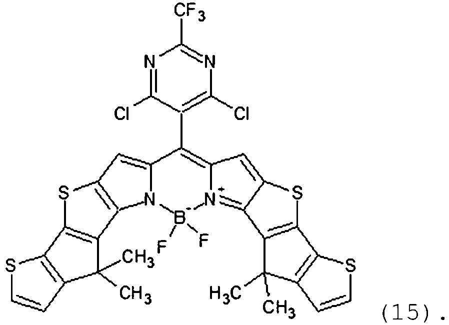

13. Composant optoélectronique (10) comprenant une première électrode (2), une deuxième électrode (6) et un système de couches (7), le système de couches (7) étant disposé entre la première électrode (2) et la deuxième électrode (6), **caractérisé en ce qu'**au moins une couche du système de couches (7) comporte au moins un composé chimique selon l'une quelconque des revendications 1 à 12.

14. Composant optoélectronique (10) selon la revendication 13, dans lequel le composant optoélectronique présente un système de couches (7) comprenant au moins une couche photoactive (4), de préférence une couche photoactive absorbant la lumière (4), l'au moins une couche photoactive (4) comportant l'au moins un au moins un composé chimique, le composant optoélectronique (10) étant de préférence un élément photovoltaïque organique, un OFET (transistor à effet de champ organique), une OLED (diode électroluminescente organique) ou un photodétecteur organique.

15. Utilisation d'un composé chimique selon l'une quelconque des revendications 1 à 12 dans un composant optoélectronique (10), de préférence dans un élément photovoltaïque organique, un OFET (transistor à effet de champ organique), une OLED (diode électroluminescente organique) ou un photodétecteur organique.
